# EUROPEAN PATENT APPLICATION

(11) **EP 4 618 725 A1**
(43) Date of publication of application: **17.09.2025**
(21) Application number: 24216165.1
(22) Date of filing: 28.11.2024
(51) Int. Cl.: H10D 84/05, H10D 30/47, H10D 84/80, H10D 89/60, H10D 62/85

(54) **SEMICONDUCTOR DEVICE**

(30) Priority: 15.03.2024 KR 20240036462
(71) Applicant: Samsung Electronics Co., Ltd., Suwon-si, Gyeonggi-do 16677 (KR)
(72) Inventor: KIM, Joonyong, Suwon-si (KR); HWANG, In Jun, Suwon-si (KR)
(74) Representative: Marks & Clerk LLP

(57) **Abstract**

A semiconductor device according to some implementations includes a main transistor, a peripheral circuit element connected to one end of the main transistor, and a Zener diode connected between the other end of the main transistor and the peripheral circuit element. The main transistor includes a main channel layer, a barrier layer disposed on the main channel layer, a main gate electrode disposed on the barrier layer, a gate semiconductor layer disposed between the barrier layer and the gate electrode, and a main source electrode and a main drain electrode connected to the main channel layer. The peripheral circuit element includes a sub-channel layer connected to the main drain electrode and including a drift region with a two-dimensional electron gas, and a detection electrode disposed on the sub-channel layer, and the Zener diode is electrically connected between the detection electrode and the main source electrode.

## Description

### BACKGROUND

The importance of power semiconductor devices used in various fields such as transportation fields (e.g., electric vehicles, railroads, and electric trams), renewable energy systems (e.g., solar power generation and wind power generation), and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, thereby handling large amounts of current and withstanding high voltage.

For example, power semiconductor devices may handle voltages from hundreds of volts to thousands of volts and currents from tens of amperes to thousands of amperes. Power semiconductor devices may improve the efficiency of electrical energy by minimizing power loss. Additionally, power semiconductor devices may be stably driven even in environments such as high temperatures.

Power semiconductor devices may be classified according to their materials, and examples include SiC power semiconductor devices and GaN power semiconductor devices. By manufacturing electric power semiconductor devices using SiC or GaN instead of existing silicon wafers (Si wafer), it is possible to compensate for the disadvantage of silicon, which has unstable characteristics at high temperatures. SiC power semiconductor devices are resistant to high temperatures and have low power loss, and may be suitable for electric vehicles, renewable energy systems, etc. GaN power semiconductor devices incur high costs, but are efficient in terms of speed and may be suitable for high-speed charging of mobile devices.

### SUMMARY

The present disclosure relates to semiconductor devices with stable electrical characteristics and improved reliability.

A semiconductor device according to some implementations of the present disclosure includes a main transistor, a peripheral circuit element connected to one end of the main transistor, and a Zener diode connected between the other end of the main transistor and the peripheral circuit element. The main transistor includes a main channel layer, a barrier layer disposed on the main channel layer and including a material having an energy band gap different from that of the main channel layer, a main gate electrode disposed on the barrier layer, a gate semiconductor layer disposed between the barrier layer and the gate electrode, and a main source electrode and a main drain electrode disposed on both sides of the gate electrode and connected to the main channel layer. The peripheral circuit element includes a sub-channel layer connected to the main drain electrode and including a drift region with a two-dimensional electron gas, and a detection electrode disposed on the sub-channel layer, and the Zener diode is electrically connected between the detection electrode and the main source electrode.

A semiconductor device according to some implementations of the present disclosure includes a main transistor, a resistance element connected to one end of the main transistor, and a Zener diode connected between the other end of the main transistor and the resistance element, wherein the main transistor includes a main channel layer, a barrier layer disposed on the main channel layer and including a material having an energy band gap different from that of the main channel layer, a gate electrode disposed on the barrier layer, a gate semiconductor layer disposed between the barrier layer and the gate electrode, and a main source electrode and a main drain electrode disposed on both sides of the gate electrode and connected to the main channel layer, wherein the resistance element includes a sub-channel layer connected to the main drain electrode and including a drift region with a two-dimensional electron gas, a sub-drain electrode connected to one side of the sub-channel layer and extending from one end of the main drain electrode, and a detection electrode connected to the other side of the sub-channel layer, wherein the width of the sub-channel layer is smaller than the width of the main channel layer, and the Zener diode is electrically connected between the detection electrode and the main source electrode.

A semiconductor device according to some implementations of the present disclosure includes a main transistor, a sub-transistor element connected to one end of the main transistor, and a Zener diode connected between the other end of the main transistor and the sub-transistor element, wherein the main transistor includes a main channel layer, a barrier layer disposed on the main channel layer and including a material having an energy band gap different from that of the main channel layer, a gate electrode disposed on the barrier layer, a gate semiconductor layer disposed between the barrier layer and the gate electrode, and a main source electrode and a main drain electrode disposed on both sides of the gate electrode and connected to the main channel layer, wherein the sub-transistor element includes a sub-channel layer connected to the main drain electrode and including a drift region with a two-dimensional electron gas, a sub-drain electrode connected to the sub-channel layer and extending from one end of the main drain electrode, a detection electrode connected to the sub-channel layer, and a sub-gate electrode disposed on the sub-channel layer and between the sub-drain electrode and the detection electrode, and the Zener diode is connected between the detection electrode and the main source electrode.

According to some implementations of the present disclosure, it is possible to improve the electrical characteristics and reliability of semiconductor devices.

At least some of the above and other features of the invention are set out in the claims.

### BRIEF DESCRIPTION OF THE DRAWINGS

FIGS. 1 is a block diagram illustrating an example of a semiconductor device.
FIG. 2 is a circuit diagram illustrating an example of a semiconductor device.
FIG. 3 is a timing diagram illustrating the gate voltage, a first power voltage, and a detection voltage of the semiconductor device of FIG. 2.
FIG. 4 is a top plan view illustrating an example of a semiconductor device.
FIGS. 5 and 6 are cross-sectional views taken along line A-A' of FIG. 4.
FIG. 7 is a cross-sectional view taken along lines B-B' and C-C' of FIG. 4.
FIG. 8 is a cross-sectional view corresponding to lines B-B' and C-C' of FIG. 4, illustrating an example of a semiconductor device.
FIG. 9 is a circuit diagram illustrating an example of a resistance unit of a semiconductor device.
FIG. 10 is a top plan view illustrating an example of a semiconductor device.
FIG. 11 is a cross-sectional view taken along line D-D' of FIG. 10.
FIG. 12 is a cross-sectional view corresponding to line D-D' of FIG. 10, illustrating peripheral circuit elements of an example of a semiconductor device.
FIG. 13 is a circuit diagram illustrating an example of a semiconductor device.
FIG. 14 is a timing diagram illustrating the gate voltage, the first power voltage, and the detection voltage of the semiconductor device of FIG. 13.
FIG. 15 is a top plan view illustrating the semiconductor device of FIG. 13.
FIG. 16 is a cross-sectional view taken along line E-E' of FIG. 15.
FIGS. 17 and 18 are cross-sectional views corresponding to E-E' of FIG. 15, illustrating peripheral circuit elements of an example of a semiconductor device.
FIG. 19 is a top plan view illustrating peripheral circuit elements of an example of a semiconductor device.
FIG. 20 is a top plan view illustrating an example of a semiconductor device.
FIG. 21 is a cross-sectional view taken along line F-F' of FIG. 20.
FIG. 22 is a circuit diagram illustrating an example of a semiconductor device.
FIG. 23 is a timing diagram illustrating the gate voltage, the first power voltage, and the detection voltage of the semiconductor device of FIG. 22.
FIG. 24 is a top plan view illustrating the semiconductor device of FIG. 22.
FIG. 25 is a cross-sectional view taken along line G-G' of FIG. 24.

### DETAILED DESCRIPTION

The present disclosure will be described in detail hereinafter with reference to the accompanying drawings, in which examples according to the present disclosure are shown. As those skilled in the art would realize, the described examples may be modified in various different ways without departing from the scope of the present disclosure.

Like reference numerals designate like elements throughout the specification.

Sizes and thicknesses of constituent elements in the drawings are arbitrarily illustrated for better understanding and ease of description; the following examples are not limited thereto. In the drawings, the thickness of layers, films, panels, regions, etc., are exaggerated for clarity. In the drawings, the thickness of some layers and regions may be exaggerated for ease of description.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is referred to as being "on" or "above" a reference element, it can be positioned above or below the reference element, and it is not necessarily referred to as being positioned "on" or "above" in a direction opposite to gravity.

In addition, unless explicitly described to the contrary, the word "comprise", and variations such as "comprises" or "comprising", will be understood to imply the inclusion of stated elements but not the exclusion of any other elements.

In addition, the phrase "on a plane" means a view from a position above the object (e.g., from the top), and the phrase "on a cross-section" means a view of a cross-section of the object which is vertically cut from the side.

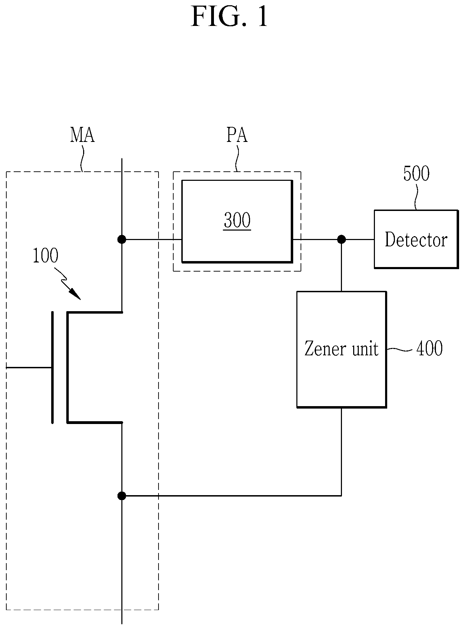

As shown in FIG. 1, a semiconductor device according to some implementations includes a main element region MA including a main transistor 100, a peripheral circuit region PA including a peripheral circuit element 300, a Zener unit 400, and a detector 500.

The main transistor 100 may be disposed in the main element region MA. For example, the main transistor 100 of the semiconductor device according to some implementations may be a normally-off high electron mobility transistor (HEMT). However, it is not limited thereto, and the main transistor 100 may be, for example, a normally-on high electron mobility transistor or another type of transistor. The main element region MA may mean a region where the main transistor 100 is disposed.

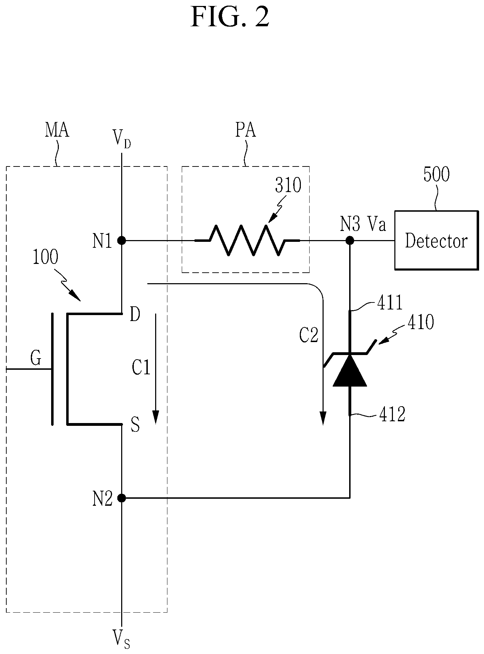

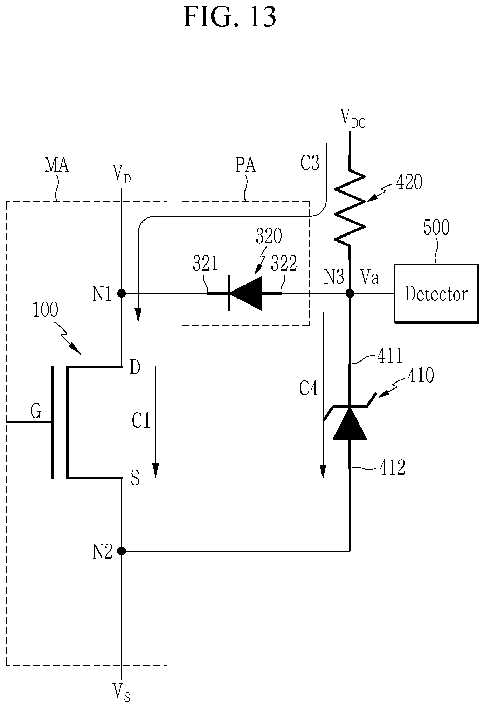

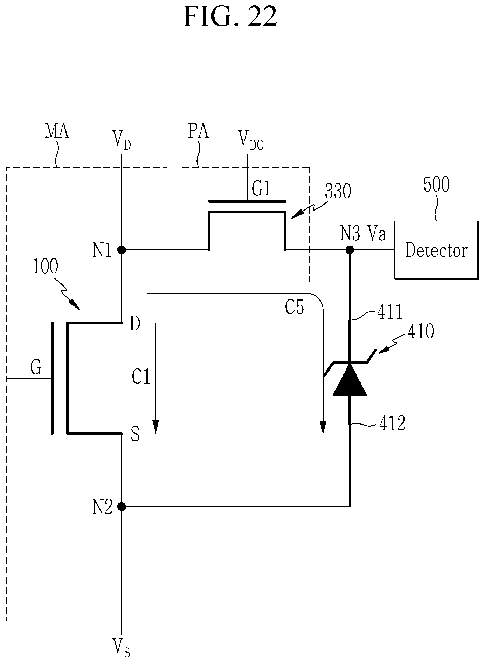

The peripheral circuit region PA may include elements electrically connected to the main transistor 100. For example, a peripheral circuit element 300 electrically connected to the main transistor 100 may be disposed in the peripheral circuit region PA. In some implementations, one end of the peripheral circuit element 300 is electrically connected to the main transistor 100, and the other end of the peripheral circuit element 300 may be connected to the Zener unit 400 and the detector 500. For example, the peripheral circuit element 300 disposed in the peripheral circuit region PA may include a resistance element (310 in FIG. 2), a diode element (320 in FIG. 13), or a sub-transistor element (330 in FIG. 22). However, it is not limited thereto, and as another example, the peripheral circuit element 300 may include passive elements such as capacitors or inductors, or may include active elements such as integrated circuit (IC) chips. As another example, the peripheral circuit elements 300 may include a current divider, a voltage divider, a voltage clipper, and a protection element for the main transistor 100. In some implementations, the peripheral circuit region PA refers to a region where the peripheral circuit element 300 is disposed. In one example, the peripheral circuit element 300 may be electrically connected to a first source or a drain of the main transistor 100.

The Zener unit 400 may be electrically connected between the peripheral circuit element 300 and the main transistor 100. One end of the Zener unit 400 may be electrically connected to the peripheral circuit element 300, and the other end of the Zener unit 400 may be electrically connected to the main transistor 100. For example, the Zener unit 400 may electrically connect the peripheral circuit element 300 and the other end of the main transistor 100 (e.g., the second electrode (D in FIG. 2) of the main transistor 100). The Zener unit 400 may be configured with the peripheral circuit element 300 to perform clipping of a voltage at one end of the Zener unit 400.

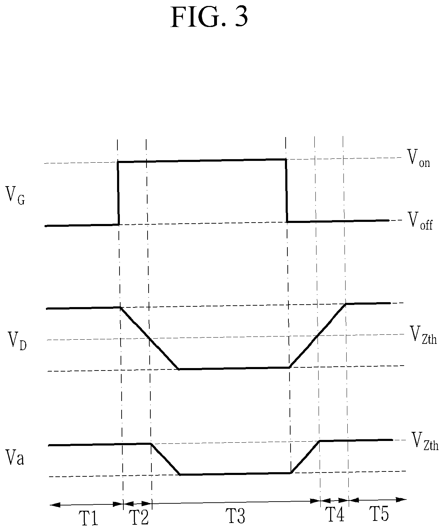

The Zener unit 400 may prevent the voltage of one end of the Zener unit 400 from rapidly increasing. For example, the Zener unit 400 may include a Zener diode (410 in FIG. 2), but is not limited thereto. Here, the Zener diode has the same characteristics as a general diode device and allows current to flow in the forward voltage, but may refer to an element made to allow reverse current to flow at a lower voltage (breakdown voltage) than a general diode device in the reverse voltage. A description of this will be provided later with further reference to FIG. 3. In one example, the Zener diode 410 may be electrically connected between a second source or drain of the main transistor 100 and the peripheral circuit element 300.

The detector 500 may be electrically connected to the peripheral circuit element 300 and the Zener unit 400. For example, the detector 500 may be electrically connected to the other end of the peripheral circuit element 300 and one end of the Zener unit 400. The detector 500 may detect the voltage of the other end of the peripheral circuit element 300 and/or the voltage of one end of the Zener unit 400. Based on the detection voltage, the detector 500 may detect a change in voltage at one end of the main transistor 100 or calculate a time period in which the main transistor 100 is turned on.

In some implementations, the detector 500 may further include an element that performs an additional operation based on the calculated change in voltage at one end of the main transistor 100 or the turn-on time period. For example, the detector 500 may further include circuits that compensate and protect the main transistor 100 and/or a semiconductor device including the same. For example, the detector 500 may detect a change in voltage at one end of the main transistor 100 or calculate a time period in which the main transistor 100 is turned on in order to compensate and protect the main transistor 100 to operate within a predetermined range. Here, a compensation circuit may refer to a circuit that compensates for the operation loss of the main transistor 100 so that the main transistor 100 operates within a predetermined range. Protection elements may be circuits that prevent semiconductor devices including the main transistor 100 from being destroyed, such as an overcurrent protection element, an overvoltage protection element, an over temperature protection element, a disconnection protection element, an electro static discharge protection element, a low drop-output (LDO) regulator, and the like. However, it is not limited thereto, and the detector 500 may further include predetermined circuits that control the operation of the main transistor 100.

FIG. 2 is a circuit diagram illustrating a semiconductor device according to some implementations. FIG. 3 is a timing diagram illustrating the gate voltage, a first power voltage, and a detection voltage of the semiconductor device of FIG. 2. Hereinafter, for better understanding and ease of description, a case where a second power voltage V_{S} has a ground voltage will be described.

Referring to FIG. 2, a semiconductor device may include the main transistor 100, the resistance element 310, the Zener diode 410, and the detector 500. In some implementations, the resistance element 310 may correspond to the peripheral circuit element 300 of FIG. 1, and the Zener diode 410 may correspond to the Zener unit 400 of FIG. 1.

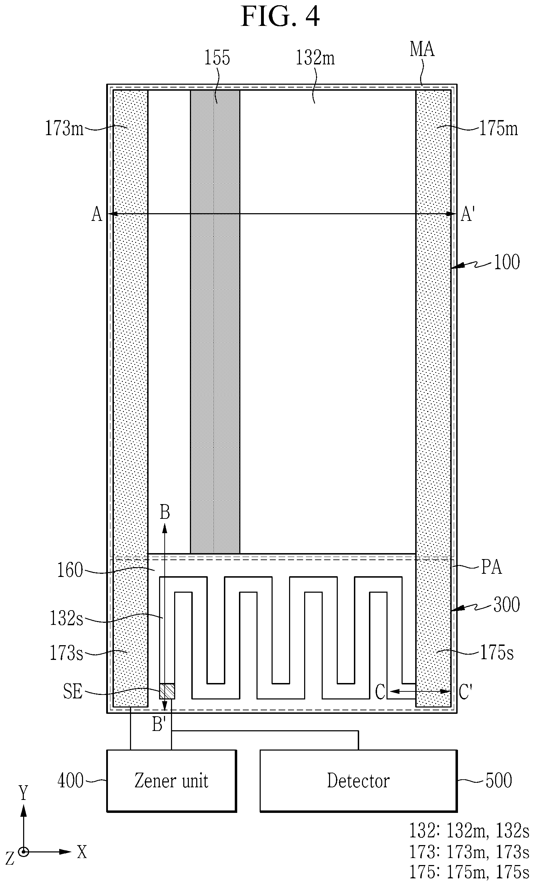

The main transistor 100 may include a main gate electrode G, a first electrode D, and a second electrode S. The main transistor 100 may control the drain-source current between the first electrode D and the second electrode S according to the gate signal applied to the main gate electrode G. For example, when a turn-on signal is applied to the main gate electrode G of the main transistor 100, current may flow along a first path C1. Here, the first path C1 may mean a path through which current flows from the first electrode D to the second electrode S of the main transistor 100. Accordingly, current may flow from a first node N1 to a second node N2 through the main transistor 100. A first power voltage V_{D} may be supplied to the first electrode D, and a second power voltage V_{S} may be supplied to the second electrode S. The value of the second power voltage V_{S} may be less than the value of the first power voltage V_{D}. For example, the second power voltage V_{S} may be a ground voltage. Here, the first electrode D may refer to the main drain electrode (175m in FIG. 4) of the main transistor 100, and the second electrode S may refer to the main source electrode (173m in FIG. 4) of the main transistor 100. Additionally, the first power voltage V_{D} may refer to the voltage applied to the main drain electrode (175m in FIG. 4) of the main transistor 100. The second power voltage V_{S} may refer to the voltage applied to the main source electrode (173m in FIG. 4) of the main transistor 100. In one example, the main transistor 100 may comprise a main channel layer, a barrier layer on the main channel layer and including a material having an energy band gap different from an energy band gap of the main channel layer, a main gate electrode on the barrier layer, a gate semiconductor layer arranged between the barrier layer and the main gate electrode, and a main source electrode and a main drain electrode disposed on respective sides of the main gate electrode and electrically connected to the main channel layer.

The resistance element 310 may be electrically connected to the first electrode D of the main transistor 100. Additionally, the resistance element 310 may be electrically connected to the Zener diode 410 and the detector 500. For example, one end of the resistance element 310 may be connected to one end of the main transistor 100 through the first node N1. For example, one end of the resistance element 310 may be electrically connected to the first electrode D of the main transistor 100 through the first node N1. For example, in some implementations, one end of the resistance element 310 may be electrically connected to the main drain electrode (175m in FIG. 4) of the main transistor 100 through the first node N1. Additionally, one end of the resistance element 310 may be connected to a first power source having the first power voltage V_{D} through the first node N1. Accordingly, the first power voltage V_{D} may be supplied to one end of the resistance element 310. The other end of the resistance element 310 may be electrically connected to the Zener diode 410 and the detector 500 through a third node N3. In some implementations, the resistance element 310 corresponds to the resistance of a sub-drift region (DTRs in FIG. 4) between a sub-drain electrode (175s in FIG. 4) and a detection electrode (SE in FIG. 4). Additionally, the third node N3 may be a point corresponding to the detection electrode (SE in FIG. 4). A description of this will be provided later with reference to FIGS. 4 to 7. In one example, the peripheral circuit element 300 (or the resitance element 310) may comprises a sub-channel layer electrically connected to the main drain electrode and including a drift region having a two-dimensional electron gas; and a detection electrode on the sub-channel layer.

The Zener diode 410 may be electrically connected between the resistance element 310 and the main transistor 100. The Zener diode 410 may include an anode 412 and a cathode 411. The cathode 411 of the Zener diode 410 may be electrically connected to the resistance element 310 through the third node N3, and the anode 412 of the Zener diode 410 may be electrically connected to the second electrode S of the main transistor 100 through the second node N2. Additionally, the anode 412 of the Zener diode 410 may be electrically connected to a second power source that supplies the second power voltage V_{S} through the second node N2. In one example, the Zener diode may be electrically connected between the detection electrode and the main source electrode.

In some implementations, the Zener diode 410 has the same characteristics as a general diode device and allows current to flow in the forward voltage, but reverse current may only flow at or above a breakdown voltage V_{Zth} at a reverse voltage. At this time, the value of the voltage applied across both ends of the Zener diode 410 may be constant as the breakdown voltage V_{Zth}. For example, current does not flow through the Zener diode 410 at a reverse voltage below the breakdown voltage V_{Zth}, but current may flow at a reverse voltage above the breakdown voltage V_{Zth}. The breakdown voltage V_{Zth} may be defined as the minimum voltage at which current may flow into the Zener diode 410 when a reverse voltage is applied to the Zener diode 410. Here, the forward direction may refer to the direction from the anode 412 of the Zener diode 410 to the cathode 411, and the reverse direction may refer to the direction from the cathode 411 of the Zener diode 410 to the anode 412. Accordingly, the Zener diode 410 may perform the role of clipping the detection voltage Va of the third node N3.

Referring further to FIG. 3, for example, when the first power voltage V_{D} is less than the breakdown voltage V_{Zth} of the Zener diode 410 (for example, the third time period T3 of FIG. 3), this is the case where a reverse voltage smaller than the breakdown voltage V_{Zth} is applied to the Zener diode 410, and current does not flow into the Zener diode 410. Accordingly, the current may not flow along the second path C2, and the value of the detection voltage Va of the third node N3 may be substantially the same as the value of the first power voltage V_{D}. In addition, when the first power voltage V_{D} is greater than the breakdown voltage V_{Zth} of the Zener diode 410 (for example, in a first time period T1 and a second time period T2 of FIG. 3), this is the case where a reverse voltage is greater than the breakdown voltage V_{Zth} is applied to the Zener diode 410, and current may flow from the cathode 411 of the Zener diode 410 to the anode 412. For example, current may flow along the second path C2. For example, the current may flow from the first node N1 to the third node N3 through the resistance element 310 and to the second node N2 through the Zener diode 410. At this time, the detection voltage Va of the third node N3 may have substantially the same value as the breakdown voltage V_{Zth} of the Zener diode 410.

Referring again to FIG. 2, the detector 500 may be connected to the third node N3. The detector 500 may be electrically connected to one end of the peripheral circuit element 300 and the cathode 411 of the Zener unit 400 through the third node N3. The detector 500 may detect the detection voltage Va of the third node N3. The detector 500 may detect a change in voltage at one end of the main transistor 100 based on the detection voltage Va.

For example, the detector 500 may detect a time period in which the value of the first power voltage V_{D} is smaller than the value of the breakdown voltage V_{Zth} based on the detection voltage Va. For example, as shown in FIG. 3, the detection voltage Va has substantially the same value as the breakdown voltage V_{Zth} in the first time period T1, the second time period T2, a fourth time period T4, and a fifth time period T5. This may mean that current flows along the second path C2. For example, in the first time period T1, the second time period T2, the fourth time period T4, and the fifth time period T5, the value of the first power voltage V_{D} may be greater than the value of the breakdown voltage V_{Zth}. Meanwhile, the detection voltage Va has a value smaller than the breakdown voltage V_{Zth} in the third time period T3. This may mean that current does not flow along the second path C2. For example, the value of the first power voltage V_{D} in the third time period T3 may be smaller than the breakdown voltage V_{Zth}.

For example, the value of the detection voltage Va may decrease in a time period where the value of the first power voltage V_{D} is smaller than the breakdown voltage V_{Zth}. Accordingly, the detector 500 may detect the time period where the value of the first power voltage V_{D} applied to the first electrode D of the main transistor 100 is smaller than the value of the breakdown voltage V_{Zth} based on the value of the detection voltage Va.

As another example, the detector 500 may detect a change in the first power voltage V_{D} based on the detection voltage Va and calculate a time period in which the main transistor 100 is turned on. Specifically, a gate voltage V_{G} may be applied to the main gate electrode G of the main transistor 100. When an on-voltage Von is applied to the main gate electrode G, the main transistor 100 may be turned on. At this time, as the main transistor 100 is turned on, the value of the first power voltage V_{D} may decrease at a predetermined interval due to a load effect or the like. Therefore, as described above, the detector 500 may detect a time period in which the detection voltage Va decreases and calculate a time period in which the value of the first power voltage V_{D} decreases, and accordingly, may also calculate the time period where the main transistor 100 turns on. In one example, when an off-voltage V_{OFF} is applied to the main gate electrode G, the main transistor may be turned off.

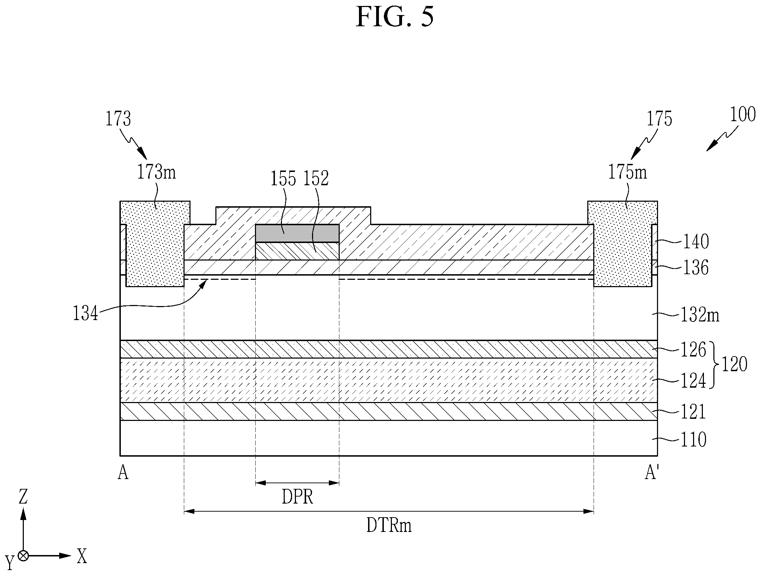

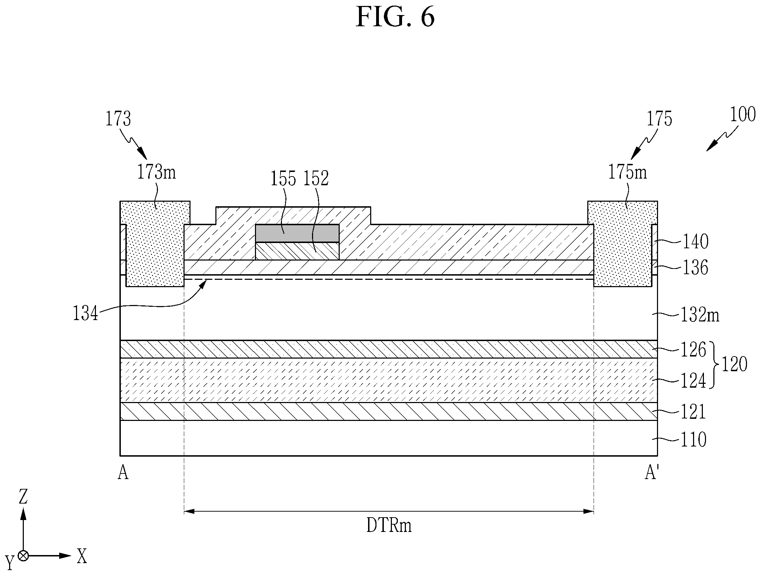

FIG. 4 is a top plan view illustrating a semiconductor device according to some implementations. FIGS. 5 and 6 are cross-sectional views taken along line A-A' of FIG. 4. FIG. 5 shows a case in which a semiconductor device according to some implementations is in an off state, and FIG. 6 shows a case in which a semiconductor device according to some implementations is in an on state.

Referring to FIG. 4, the peripheral circuit region PA of the semiconductor device may be disposed spaced apart from the main element region MA. For example, the peripheral circuit region PA may be disposed spaced apart from the main element region MA in the second direction (Y direction), but is not limited thereto. For example, the peripheral circuit region PA may be positioned spaced apart from the main element region MA in a first direction (X direction), or may surround the side of the main element region MA. Various other modifications are possible. In some implementations, a separation structure 160 may be disposed between the peripheral circuit region PA and the main element region MA, but is not limited thereto. In some implementations, the peripheral circuit region PA is adjacent to the main element region MA.

Referring further to FIG. 5, the main transistor 100 of the semiconductor device may include a main channel layer 132m, a barrier layer 136 disposed on the main channel layer 132m, a main gate electrode 155 disposed on the barrier layer 136, a gate semiconductor layer 152 disposed between the barrier layer 136 and the main gate electrode 155, a protective layer 140 disposed on the barrier layer 136, and a main source electrode 173m and a main drain electrode 175m spaced apart from each other on the main channel layer 132m.

The main channel layer 132m is a layer that forms a channel between the main source electrode 173m and the main drain electrode 175m, and a two-dimensional electron gas (2DEG) 134 may be disposed inside the main channel layer 132m. The two-dimensional electron gas 134 is a charge transport model used in solid physics, which refers to a group of electrons that may move freely in two-dimensions (for example, in the x-y plane direction), but are firmly confined within the two-dimensions and cannot move in another dimension (for example, in the z direction). For example, the two-dimensional electron gas 134 may exist in a two-dimensional paper-like form within a three-dimensional space. The two-dimensional electron gas 134 mainly appears in a semiconductor heterojunction structure, and may occur at the interface between the main channel layer 132m and the barrier layer 136 in the semiconductor devices described herein. For example, the two-dimensional electron gas 134 may be generated in a portion of the main channel layer 132m adjacent to the barrier layer 136.

The main channel layer 132m may include one or more materials selected from group III-V materials, such as nitrides containing Al, Ga, In, B, or a combination thereof. The main channel layer 132m may be made of a single layer or multiple layers. The main channel layer 132m may be AlₓIn_{y}Ga_{1-x-y}N (0≤x≤1, 0≤y≤1, x+y≤1). For example, the main channel layer 132m may include AIN, GaN, InN, InGaN, AlGaN, AllnN, AllnGaN, or a combination thereof. The main channel layer 132m may be a layer doped with impurities or a layer undoped with impurities. The thickness of the main channel layer 132m may be about several hundred nm or less.

The main channel layer 132m may be disposed on the substrate 110, and a seed layer 121 and a buffer layer 120 may be positioned between the substrate 110 and the main channel layer 132m. The substrate 110, seed layer 121, and buffer layer 120 are layers used to form the main channel layer 132m, and may be omitted in some cases. For example, when a substrate made of GaN is used as the main channel layer 132m, at least one of the substrate 110, the seed layer 121, and the buffer layer 120 may be omitted. Considering that the price of a substrate made of GaN is relatively high, the main channel layer 132m containing GaN may be grown using the substrate 110 made of Si. As the lattice structure of Si and GaN are different, it may not be easy to grow the main channel layer 132m directly on the substrate 110. Accordingly, the seed layer 121 and the buffer layer 120 may first be grown on the substrate 110, and then the main channel layer 132m may be grown on the buffer layer 120. Additionally, at least one of the substrate 110, the seed layer 121, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited thereto, and any commonly used substrate may be applied. In some cases, the substrate 110 may include an insulating material. For example, several layers, including the main channel layer 132m, may be first formed on a semiconductor substrate, then the semiconductor substrate may be removed and replaced with an insulating substrate.

The seed layer 121 may be disposed directly on the substrate 110. However, it is not limited thereto, and another predetermined layer may be further disposed between the substrate 110 and the seed layer 121. The seed layer 121 is a layer that serves as a seed for growing the buffer layer 120, and may be made of a crystal lattice structure that serves as a seed for the buffer layer 120. The buffer layer 120 may be disposed directly on the seed layer 121. However, the arrangement is not limited thereto, and another predetermined layer may be further disposed between the seed layer 121 and the buffer layer 120. The seed layer 121 may include one or more materials selected from group III-V materials, for example, nitrides containing Al, Ga, In, B, or a combination thereof. The seed layer 121 may be AlₓIn_{y}Ga_{1-x-y}N (0≤x≤1, 0≤y≤1, x+y≤1). For example, the seed layer 122 may include AIN, GaN, InN, InGaN, AlGaN, AllnN, AllnGaN, or a combination thereof.

The buffer layer 120 may be disposed on the seed layer 121. The buffer layer 120 may be disposed between the seed layer 121 and the main channel layer 132m. The buffer layer 120 may be a layer to alleviate the difference in lattice constant and thermal expansion coefficient between the seed layer 121 and the main channel layer 132m or to prevent parasitic current (leakage current) from flowing through the main channel layer 132m. The buffer layer 120 may include one or more materials selected from group III-V materials, for example, nitrides containing Al, Ga, In, B, or a combination thereof. The buffer layer 120 may be AlₓIn_{y}Ga_{1-x-y}N (0≤x≤1, 0≤y≤1, x+y≤1). For example, the buffer layer 120 may include AIN, GaN, InN, InGaN, AlGaN, AllnN, AllnGaN, or a combination thereof.

The buffer layer 120 of the semiconductor device according to some implementations may include a superlattice layer 124 disposed on the seed layer 121, and a high-resistance layer 126 disposed on the superlattice layer 124. The superlattice layer 124 and the high-resistance layer 126 may be sequentially disposed on the substrate 110.

The superlattice layer 124 may be disposed on the seed layer 121. The superlattice layer 124 may be disposed directly on the seed layer 121. However, the arrangement is not limited thereto, and another predetermined layer may be further disposed between the seed layer 121 and the superlattice layer 124. The superlattice layer 124 is a layer for alleviating the difference in lattice constant and thermal expansion coefficient between the substrate 110 and the main channel layer 132m, thereby alleviating a tensile stress and compressive stress generated between the substrate 110 and the main channel layer 132m, and alleviating stress between all layers formed by growth in the final structure of a semiconductor device according to some implementations. The superlattice layer 124 may include one or more materials selected from group III-V materials, for example, nitrides containing Al, Ga, In, B, or a combination thereof. The superlattice layer 124 may be AlₓIn_{y}Ga_{1-x-y}N (0≤x≤1, 0≤y≤1, x+y≤1). For example, the superlattice layer 124 may include AIN, GaN, InN, InGaN, AlGaN, AllnN, AllnGaN, or a combination thereof.

In some implementations, the superlattice layer 124 is made of multiple layers in which layers containing different materials which are alternately stacked. For example, the superlattice layer 124 may have a structure in which a layer made of AlGaN and a layer made of AIN are repeatedly stacked. That is, AIGaN/AIN/AIGaN/AIN/AIGaN/AIN may be sequentially stacked to form a superlattice layer. The number of AlGaN layers and GaN included in the superlattice layer 124 may vary, and the material included in the superlattice layer 124 may vary. As another example, the superlattice layer 124 may have a structure in which a layer made of AlGaN and a layer made of GaN are repeatedly stacked. That is, AIGaN/GaN/AIGaN/GaN/AIGaN/GaN may be sequentially stacked to form a superlattice layer. In some implementations, when the superlattice layer 124 includes GaN, InN, AlGaN, AllnN, InGaN, AIN, AllnGaN, or a combination thereof, the superlattice layer 124 may have larger n-type semiconductor characteristics where the concentration of electrons is greater than the concentration of holes, but is not limited thereto.

The high-resistance layer 126 may be disposed on the superlattice layer 124. The high-resistance layer 126 may be disposed directly on the superlattice layer 124. However, the arrangement is not limited thereto, and another predetermined layer may be further disposed between the superlattice layer 124 and the high-resistance layer 126. The high-resistance layer 126 may be disposed between the superlattice layer 124 and the main channel layer 132m. The high-resistance layer 126 is a layer for preventing deterioration of the semiconductor device by preventing leakage current from flowing through the main channel layer 132m. The high-resistance layer 126 may be made of a low-conductivity material to electrically insulate the substrate 110 and the main channel layer 132m. The high-resistance layer may include one or more materials selected from group III-V materials, such as nitrides containing Al, Ga, In, B, or combinations thereof. The high-resistance layer 126 may be AlₓIn_{y}Ga_{1-x-y}N (0≤x≤1, 0≤y≤1, x+y≤1). For example, the high-resistance layer 126 may include AIN, GaN, InN, InGaN, AlGaN, AllnN, AllnGaN, or a combination thereof. The high-resistance layer 126 may be made of a single layer or multiple layers. In some implementations, when the superlattice layer 124 includes GaN, InN, AlGaN, AllnN, InGaN, AIN, AllnGaN, or a combination thereof, the high-resistance layer 126 may have larger n-type semiconductor characteristics where the concentration of electrons is greater than the concentration of holes, but is not limited thereto.

The barrier layer 136 may be disposed on the main channel layer 132m. The barrier layer 136 may be disposed directly on the channel layer 132. However, the arrangement is not limited thereto, and another predetermined layer may be further disposed between the main channel layer 132m and the barrier layer 136. The region of the main channel layer 132m that overlaps the barrier layer 136 between the main source electrode 173m and the main drain electrode 175m may be a main drift region DTRm. The main drift region DTRm may be disposed between the main source electrode 173m and the main drain electrode 175m. The main drift region DTRm may refer to a region where carriers move when a potential difference occurs between the main source electrode 173m and the main drain electrode 175m.

The semiconductor device may be turned on/off depending on whether a voltage is applied to the main gate electrode 155 and/or the magnitude of the voltage applied to the main gate electrode 155, and accordingly, movement of the carrier may be achieved or blocked in the main drift region DTRm.

The barrier layer 136 may include one or more materials selected from group III-V materials, for example, nitrides containing Al, Ga, In, B, or a combination thereof.

The barrier layer 136 may be AlₓIn_{y}Ga_{1-x-y}N (0≤x≤1, 0≤y≤1, x+y≤1). The barrier layer 136 may include GaN, InN, AlGaN, AllnN, InGaN, AIN, AllnGaN, or a combination thereof. The energy band gap of the barrier layer 136 may be adjusted by the composition ratio of Al and/or In. The barrier layer 136 may be doped with a predetermined impurity. The impurity doped into the barrier layer 136 may be a p-type dopant that may provide holes. For example, the impurity doped into the barrier layer 136 may be magnesium (Mg). By increasing or decreasing the impurity doping concentration of the barrier layer 136, the threshold voltage, on-resistance, etc., of the semiconductor device may be adjusted.

The barrier layer 136 may include a semiconductor material having different characteristics from the main channel layer 132m. The barrier layer 136 may be different from the main channel layer 132m in at least one of polarization characteristics, energy band gap, or lattice constant. For example, the barrier layer 136 may include a material having a different energy band gap from the main channel layer 132m. The barrier layer 136 may have a higher energy band gap than the main channel layer 132m, and may have a higher electrical polarization rate than the main channel layer 132m. The two-dimensional electron gas 134 may be induced in the main channel layer 132m having a relatively low electrical polarization rate by the barrier layer 136. In this regard, the barrier layer 136 may also be referred to as a channel supply layer or a two-dimensional electron gas supply layer. The two-dimensional electron gas 134 may be formed within the portion of the main channel layer 132m disposed below the interface between the main channel layer 132m and the barrier layer 136. The two-dimensional electron gas 134 may have very high electron mobility.

The barrier layer 136 may be made of a single layer or multiple layers. When the barrier layer 136 is made of multiple layers, the materials of each layer included in the multiple layers may have different energy band gaps. The various layers included in the barrier layer 136 may be arranged so that the energy band gap increases as the layers approach the main channel layer 132m.

The main gate electrode 155 may be disposed on the barrier layer 136. The main gate electrode 155 may overlap a portion of the barrier layer 136 in a vertical direction (e.g., the thickness direction of the main channel layer 132m). The main gate electrode 155 may overlap a portion of the main drift region DTRm of the main channel layer 132m in a vertical direction (e.g., the thickness direction of the main channel layer 132m). The main gate electrode 155 may be disposed between the main source electrode 173m and the main drain electrode 175m. The main gate electrode 155 may be spaced apart from the main source electrode 173m and the main drain electrode 175m. For example, the main gate electrode 155 may be disposed closer to the main source electrode 173m than the main drain electrode 175m. For example, the separation distance between the main gate electrode 155 and the main source electrode 173m may be less than the separation distance between the main gate electrode 155 and the main drain electrode 175m, but the arrangement is not limited thereto.

The main gate electrode 155 may include a conductive material. For example, the main gate electrode 155 may include metal, metal alloy, conductive metal nitride, metal silicide, doped semiconductor material, conductive metal oxide, or conductive metal nitride. For example, the main gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The main gate electrode 155 may be made of a single layer or multiple layers.

The gate semiconductor layer 152 may be disposed between the barrier layer 136 and the main gate electrode 155. For example, the gate semiconductor layer 152 may be disposed on the barrier layer 136, and the main gate electrode 155 may be disposed on the gate semiconductor layer 152. The main gate electrode 155 may be in Schottky contact or ohmic contact with the gate semiconductor layer 152. The gate semiconductor layer 152 may overlap the main gate electrode 155 in a vertical direction (e.g., the thickness direction of the main channel layer 132m). The gate semiconductor layer 152 may completely overlap the main gate electrode 155 in a vertical direction (e.g., in the thickness direction of the main channel layer 132m), and the upper surface of the gate semiconductor layer 152 may be entirely covered by the main gate electrode 155. For example, the gate semiconductor layer 152 may have substantially the same planar shape as the main gate electrode 155. However, the shape/arrangement is not limited thereto, and the main gate electrode 155 may be positioned to cover at least a portion of the gate semiconductor layer 152.

The gate semiconductor layer 152 may be disposed between the main source electrode 173m and the main drain electrode 175m. The gate semiconductor layer 152 may be spaced apart from the main source electrode 173m and the main drain electrode 175m. The gate semiconductor layer 152 may be disposed closer to the main source electrode 173m than the main drain electrode 175m. For example, the separation distance between the gate semiconductor layer 152 and the main source electrode 173m may be less than the separation distance between the gate semiconductor layer 152 and the main drain electrode 175m, but the arrangement is not limited thereto.

In some implementations, the gate semiconductor layer 152 may overlap the main gate electrode 155 in a vertical direction (e.g., the thickness direction of the main channel layer 132m). For example, the gate semiconductor layer 152 may completely overlap the main gate electrode 155 in a vertical direction (e.g., the thickness direction of the main channel layer 132m). For example, the side surface of the gate semiconductor layer 152 may be aligned with the side surface of the main gate electrode 155. However, the arrangement is not limited thereto, and the gate semiconductor layer 152 may partially overlap the main gate electrode 155.

The gate semiconductor layer 152 may include one or more materials selected from Group III-V materials, for example, nitrides containing Al, Ga, In, B, or a combination thereof. The gate semiconductor layer 152 may be AlₓIn_{y}Ga_{1-x-y}N (0≤x≤1, 0≤y≤1, x+y≤1). For example, the gate semiconductor layer 152 may include AIN, GaN, InN, InGaN, AlGaN, AllnN, AllnGaN, or a combination thereof. The gate semiconductor layer 152 may include a material having an energy band gap different from that of the barrier layer 136. For example, the gate semiconductor layer 152 may include GaN, and the barrier layer 136 may include AlGaN. The gate semiconductor layer 152 may be doped with a predetermined impurity. The impurity doped into the gate semiconductor layer 152 may be a p-type dopant that may provide holes. For example, the gate semiconductor layer 152 may include GaN doped with p-type impurities. For example, the gate semiconductor layer 152 may be made of a p-GaN layer. However, it is not limited thereto, and the gate semiconductor layer 152 may be, for example, a p-AlGaN layer. The impurity doped into the gate semiconductor layer 152 may be magnesium (Mg). When a predetermined element adjacent to the impurity (e.g., magnesium) doped in the gate semiconductor layer 152 combines, the hole concentration in the gate semiconductor layer 152 may be reduced, thereby deteriorating the characteristics of the semiconductor device. The gate semiconductor layer 152 may be made of a single layer or multiple layers.

A depletion region DPR may be formed in the main channel layer 132m by the gate semiconductor layer 152. The depletion region DPR may be disposed within the main drift region DTRm and may have a narrower width than the main drift region DTRm. As the gate semiconductor layer 152 having an energy band gap different from that of the barrier layer 136 is disposed on the barrier layer 136, the level of the energy band of the portion of the barrier layer 136 that overlaps the gate semiconductor layer 152 may increase. Accordingly, the depletion region DPR may be formed in the region of the main channel layer 132m that overlaps the gate semiconductor layer 152. The depletion region DPR may be a region in the channel path of the main channel layer 132m where the two-dimensional electron gas 134 is not formed or has a lower electron concentration than the remaining regions. That is, the depletion region DPR may mean a region where the flow of the two-dimensional electron gas 134 is interrupted within the main drift region DTRm. As the depletion region DPR occurs, current does not flow between the main source electrode 173m and the main drain electrode 175m, and the channel path may be blocked. Accordingly, the semiconductor device according to some implementations may have normally-off characteristics.

For example, the semiconductor device according to some implementations may be a normally-off high electron mobility transistor (HEMT). As shown in FIG. 5, in a normal state in which no voltage is applied to the main gate electrode 155, the depletion region DPR exists, and the semiconductor device according to some implementations may be in an off state. As shown in FIG. 6, when a voltage greater than the threshold voltage is applied to the main gate electrode 155, the depletion region DPR disappears, and the two-dimensional electron gas 134 within the main drift region DTRm may be continuously connected without being interrupted. For example, the two-dimensional electron gas 134 may be formed throughout the channel path between the main source electrode 173m and the main drain electrode 175m, and the semiconductor device according to some implementations may be in an on state. In summary, the semiconductor device may include semiconductor layers with different electrical polarization characteristics, and a semiconductor layer with a relatively large polarization may induce the two-dimensional electron gas 134 to another semiconductor layer which is heterogeneously junctioned therewith. The two-dimensional electron gas 134 may be used as a channel between the main source electrode 173m and the main drain electrode 175m, and the flow or interruption of this two-dimensional electron gas 134 may be controlled by the bias voltage applied to the main gate electrode 155m. In the gate-off state, the flow of the two-dimensional electron gas 134 is blocked, so current may not flow between the main source electrode 173m and the main drain electrode 175m. As the two-dimensional electron gas 134 continues to flow in the gate-on state, current may flow between the main source electrode 173m and the main drain electrode 175m.

Although the case where the semiconductor device is a normally-off high electron mobility transistor has been described above, the present disclosure is not limited thereto. For example, the semiconductor device according to some implementations may be a normally-on high electron mobility transistor. In the case of a normally-on high electron mobility transistor, the gate semiconductor layer 152 may be omitted, and thus the main gate electrode 155 may be disposed directly on the barrier layer 136. For example, the main gate electrode 155 may contact the barrier layer 136. In this structure, the two-dimensional electron gas 134 may be used as a channel while no voltage is applied to the main gate electrode 155, and current flow may occur between the main source electrode 173m and the main drain electrode 175m. Additionally, when a negative voltage is applied to the main gate electrode 155, a depletion region DPR in which the flow of the two-dimensional electron gas 134 is interrupted may occur at the bottom of the main gate electrode 155.

The above-described seed layer 121, superlattice layer 124, high-resistance layer 126, main channel layer 132m, barrier layer 136, and gate semiconductor layer 152 may be sequentially stacked on the substrate 110. In the semiconductor device according to some implementations, at least one of the seed layer 121, the superlattice layer 124, the high-resistance layer 126, the main channel layer 132m, the barrier layer 136, and the gate semiconductor layer 152 may be omitted. The seed layer 121, superlattice layer 124, high-resistance layer 126, main channel layer 132m, barrier layer 136, and gate semiconductor layer 152 may be made of the same base semiconductor material, and the material composition ratio of each layer may be different, considering the role of each layer and the performance required for the semiconductor device.

The protective layer 140 may be disposed on the barrier layer 136 and the main gate electrode 155. The protective layer 140 may cover the upper and side surfaces of the main gate electrode 155 and the side surfaces of the gate semiconductor layer 152. The lower surface of the protective layer 140 may be in contact with the barrier layer 136 and the main gate electrode 155. Accordingly, the barrier layer 136, the gate semiconductor layer 152, and the main gate electrode 155 may be protected by the protective layer 140. However, the arrangement is not limited thereto, and the main gate electrode 155 may penetrate the protective layer 140 and connect to the gate semiconductor layer 152. Additionally, the protective layer 140 may not cover the upper surface of the main gate electrode 155. Alternatively, the lower surface of the protective layer 140 may contact the gate semiconductor layer 152. The protective layer 140 may include an insulating material. For example, the protective layer 140 may include an oxide such as SiO₂ or Al₂O₃. As another example, the protective layer 140 may include a nitride such as SiN or an oxynitride such as SiON.

In FIGS. 5 and 6, the protective layer 140 is shown as being made of a single layer, but the present disclosure is not limited thereto, and the protective layer 140 may be made of multiple layers containing different materials.

The main source electrode 173m and the main drain electrode 175m may be disposed on the main channel layer 132m. The main source electrode 173m and the main drain electrode 175m may be in direct contact with the main channel layer 132m and electrically connected to the main channel layer 132m. The main source electrode 173m and the drain electrode 175 may be spaced apart from each other, and the gate electrode 155 and the gate semiconductor layer 152 may be disposed between the source electrode 173 and the drain electrode 175. The gate electrode 155 and the gate semiconductor layer 152 may be spaced apart from the main source electrode 173m and the main drain electrode 175m. For example, the main source electrode 173m may be electrically connected to the main channel layer 132m on one side of the main gate electrode 155, and the main drain electrode 175m may be electrically connected to the main channel layer 132m on the other side of the main gate electrode 155. The main source electrode 173m and the main drain electrode 175m may be disposed outside the main drift region DTRm of the main channel layer 132m. The boundary surface between the main source electrode 173m and the main channel layer 132m may be one edge of the main drift region DTRm. Likewise, the boundary surface between the main drain electrode 175m and the main channel layer 132m may be the other edge of the main drift region DTRm.

However, the present disclosure is not limited thereto, and the main source electrode 173m and the main drain electrode 175m may not be disposed on the outer surface of the main drift region DTRm of the main channel layer 132m. For example, the main channel layer 132m may not be recessed, and the main source electrode 173m and the main drain electrode 175m may be disposed on the upper surface of the main channel layer 132m. In this case, the bottom surfaces of the main source electrode 173m and the main drain electrode 175m may contact the upper surface of the main channel layer 132m. A portion of the main channel layer 132m in contact with the main source electrode 173m and the main drain electrode 175m may be doped at a high concentration. In that case, the carrier that has passed through the two-dimensional electron gas 134 may be transmitted to the main source electrode 173m and the main drain electrode 175m after passing through the portion of the main channel layer 132m that is doped at a high concentration, i.e., the upper portion of the two-dimensional electron gas 134. The main source electrode 173m and the main drain electrode 175m may not directly contact the two-dimensional electron gas 134 in the horizontal direction. Here, the horizontal direction may mean a direction parallel to the upper surface of the main channel layer 132m or the barrier layer 136.

For example, a trench that penetrates the protective layer 140 and the barrier layer 136, and a recess in the upper surface of the main channel layer 132m, may be disposed on both sides of the main gate electrode 155 to be spaced apart from each other. The main source electrode 173m and the main drain electrode 175m may be disposed in the trench disposed on both sides of the main gate electrode 155, respectively. The main source electrode 173m and the main drain electrode 175m may be formed to fill the trench. Within the trench, the main source electrode 173m and the main drain electrode 175m may be in contact with the main channel layer 132m and the barrier layer 136. The main channel layer 132m may form the bottom and side walls of the trench, and the barrier layer 136 may form the side walls of the trench. Accordingly, the main source electrode 173m and the main drain electrode 175m may contact the upper and side surfaces of the main channel layer 132m. Additionally, the main source electrode 173m and the main drain electrode 175m may contact the side of the barrier layer 136. That is, the main source electrode 173m and the main drain electrode 175m may cover the side surfaces of the main channel layer 132m and the barrier layer 136.

In some implementations, the main source electrode 173m and the main drain electrode 175m may cover at least a portion of the side surface of the protective layer 140. For example, the main source electrode 173m and the main drain electrode 175m may cover the side surfaces of the protective layer 140. The upper surfaces of the main source electrode 173m and the main drain electrode 175m may protrude from the upper surface of the protective layer 140. Additionally, at least one of the main source electrode 173m and the main drain electrode 175m may cover at least a portion of the upper surface of the protective layer 140. However, the present disclosure is not limited thereto, and the main source electrode 173m and the main drain electrode 175m may cover at least part of the side surface of the protective layer 140 and may not cover the remaining portion of the side surface of the protective layer 140. In this case, the remaining portion of the protective layer 140 may be disposed on the upper surfaces of the main source electrode 173m and the main drain electrode 175m.

The main source electrode 173m and the main drain electrode 175m may include a conductive material. For example, the main source electrode 173m and the main drain electrode 175m may include metal, metal alloy, conductive metal nitride, metal silicide, doped semiconductor material, conductive metal oxide, or conductive metal nitride. For example, the main source electrode 173m and the main drain electrode 175m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The main source electrode 173m and the main drain electrode 175m may be made of a single layer or multiple layers. The main source electrode 173m and the main drain electrode 175m may be in ohmic contact with the main channel layer 132m. The region in contact with the main source electrode 173m and the main drain electrode 175m within the main channel layer 132m may be doped at a relatively high concentration compared to other regions.

Although FIGS. 5 and 6 show that the semiconductor device includes a pair of main source electrodes 173m and main drain electrodes 175m, the number of main source electrodes 173m and main drain electrodes 175m is not limited thereto. For example, the main source electrode 173m may include a plurality of source electrodes sequentially stacked on the main channel layer 132m in a vertical direction (e.g., in the thickness direction of the main channel layer 132m), the main drain electrode 175m may include a plurality of drain electrodes sequentially stacked on the main channel layer 132m in a vertical direction (e.g., in the thickness direction of the main channel layer 132m). Each of the main source electrode 173m and the main drain electrode 175m may include three or more layers.

The semiconductor device may further include a field dispersion layer that covers at least a portion of the protective layer 140.

The field dispersion layer may be disposed between the main source electrode 173m and the main drain electrode 175m. The field dispersion layer may cover the main gate electrode 155. The field dispersion layer may overlap the main gate electrode 155 in a vertical direction (e.g., in the thickness direction of the main channel layer 132m). The field dispersion layer may be electrically connected to the main source electrode 173m. For example, the field dispersion layer may be connected to the main source electrode 173m. The field dispersion layer may include the same material as the main source electrode 173m and may be disposed in the same layer as the main source electrode 173m. The field dispersion layer may be formed simultaneously in the same process as the main source electrode 173m. For example, the boundary between the field dispersion layer and the main source electrode 173m may not be clear, and the field dispersion layer may be formed integrally with the main source electrode 173m. However, the arrangement is not limited thereto, and the field dispersion layer may be a separate component separated from the main source electrode 173m. Additionally, the field dispersion layer may be disposed in a different layer from the main source electrode 173m and may be formed in a different process.

The field dispersion layer may serve to disperse the electric field concentrated around the main gate electrode 155. For example, in the gate-off state, the portion of the main channel layer 132m disposed between the main gate electrode 155 and the main source electrode 173m and the portion of the main channel layer 132m disposed between the main gate electrode 155 and the main drain electrode 175m may have a very high concentration of two-dimensional electron gas 134. In this case, an electric field may be concentrated on the main gate electrode 155 or the gate semiconductor layer 152. Meanwhile, the main gate electrode 155 and the gate semiconductor layer 152 are vulnerable to electric fields, so when electric fields are concentrated, leakage current may increase and breakdown voltage of the main transistor 100 may decrease. In that case, the electric field concentrated around the main gate electrode 155 or the gate semiconductor layer 152 may be dispersed by the field dispersion layer, so that leakage current may be reduced and the breakdown voltage V_{Zth} may be increased.

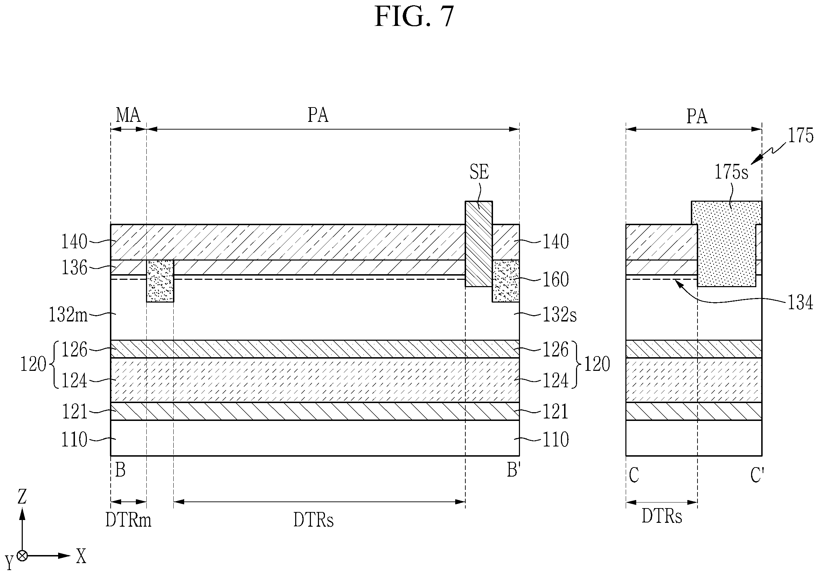

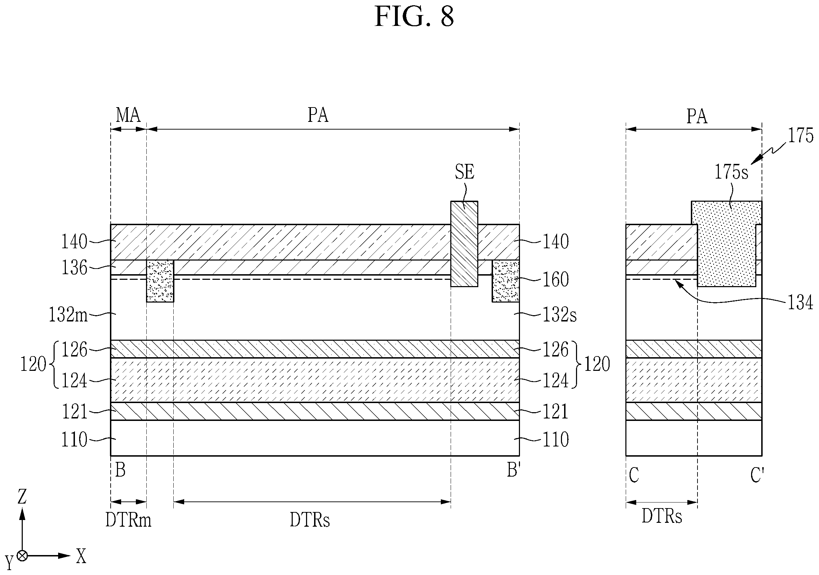

FIG. 7 is a cross-sectional view taken along lines B-B' and C-C' of FIG. 4. FIG. 8 is a cross-sectional view corresponding to lines B-B' and C-C' of FIG. 4 showing semiconductor devices according to some implementations. The peripheral circuit element 300 of the semiconductor device according to FIGS. 4, 7, and 8 may correspond to the resistance element 310 of the example of FIG. 2. Additionally, the Zener unit 400 of the semiconductor device according to FIGS. 4, 7, and 8 may correspond to the Zener diode 410 of the example of FIG. 2. Hereinafter, a case where the peripheral circuit element 300 of a semiconductor device is the resistance element 310 and the Zener unit 400 is the Zener diode 410 will be described.

Referring to FIGS. 4 and 7, the peripheral circuit element 300 of the semiconductor device may be connected to the main drain electrode 175m, and may include a sub-channel layer 132s including a drift region with two-dimensional electron gas, the barrier layer 136 disposed on the sub-channel layer 132s, a sub-drain electrode 175s and the detection electrode SE disposed on the sub-channel layer 132s, and a sub-source electrode 173s spaced apart from the sub-channel layer 132s. In one example, the peripheral circuit element 300 may comprise a sub-drain electrode electrically connected to the sub-channel layer. The sub-drain electrode may be disposed on a same layer as the main drain electrode. The peripheral circuit element 300 may comprise a sub-source electrode, electrically connected to the main source electrode and spaced apart from the sub-channel layer, and disposed on a same layer as the main source electrode, and the sub-channel layer may be disposed on a same layer as the main channel layer.

The sub-channel layer 132s may be disposed on the substrate 110. The sub-channel layer 132s is a layer that forms a channel between the sub-drain electrode 175s and the detection electrode SE, and the two-dimensional electron gas (2DEG) 134 may be disposed inside the sub-channel layer 132s. The two-dimensional electron gas 134 may be generated at the interface between the sub-channel layer 132s and the barrier layer 136 in the semiconductor device according to some implementations. For example, the two-dimensional electron gas 134 may be generated in a portion adjacent to the barrier layer 136 within the sub-channel layer 132s.

In some implementations, the sub-channel layer 132s may include a plurality of portions extending in the first direction (X direction) and a plurality of portions extending in a second direction (Y direction). For example, as shown in FIG. 4, the sub-channel layer 132s may alternately have a portion extending in the first direction (X direction) and a portion extending in the second direction (Y direction) from one side of the sub-drain electrode 175s. This may be a shape to obtain a target length of the sub-channel layer 132s in a unit area. However, this is only an example, and the extension direction of the sub-channel layer 132s is not limited thereto. For example, the sub-channel layer 132s may extend in only one direction from one side of the main channel layer 132m, or may include a plurality of bent portions. As another example, the sub-channel layer 132s may include a portion extending diagonally intersecting the first direction (X direction) and the second direction (Y direction). In some implementations, the sub-channel layer 132s may be extended to have a predetermined length. Here, the extension length of the sub-channel layer 132s may mean the total length of the sub-channel layer 132s. The width of the sub-channel layer 132s may be smaller than the width of the main channel layer 132m. Here, the width of the sub-channel layer 132s may refer to the width along the direction perpendicular to the direction in which the sub-channel layer 132s extends. The width of the main channel layer 132m may refer to the width of the main channel layer 132m in the second direction (Y direction). In this range, the sub-channel layer 132s may function as a resistance element 310.

In some implementations, one end of the sub-channel layer 132s may contact the sub-drain electrode 175s. The sub-channel layer 132s may be electrically connected to the main drain electrode 175m through the sub-drain electrode 175s.

In some implementations, the sub-channel layer 132s may be formed integrally with the main channel layer 132m of the main transistor 100 through the same process. The sub-channel layer 132s may be disposed on the same layer as the main channel layer 132m. The lower surface of the sub-channel layer 132s may be disposed at the same level as the lower surface of the main channel layer 132m, and the upper surface of the sub-channel layer 132s may be disposed at the same level as the upper surface of the main channel layer 132m. For example, the lower surface of the sub-channel layer 132s may be disposed at the same distance from the lower surface of the main channel layer 132m and the upper surface of the substrate 110. Additionally, the upper surface of the sub-channel layer 132s may be disposed at substantially the same distance from the upper surface of the main channel layer 132m and the upper surface of the substrate 110. The thickness of the sub-channel layer 132s along the third direction (Z-direction) may be substantially the same as the thickness of the main channel layer 132m along the third direction (Z-direction), but is not limited thereto. The sub-channel layer 132s may refer to a portion of the main channel layer 132m disposed in the peripheral circuit region PA.

In some implementations, the sub-channel layer 132s includes the same material as the main channel layer 132m disposed in the main element region MA. For example, the sub-channel layer 132s may include one or more materials selected from group III-V materials, such as nitrides containing Al, Ga, In, B, or a combination thereof.

The sub-channel layer 132s may be disposed on the substrate 110, and the seed layer 121 and the buffer layer 120 may be disposed between the substrate 110 and the sub-channel layer 132s. The substrate 110, seed layer 121, and buffer layer 120 are layers used to form the sub-channel layer 132s, and may be omitted in some cases. In some implementations, the substrate 110, the seed layer 121, and the buffer layer 120 disposed in the peripheral circuit region PA may be formed integrally through the same process as the substrate 110, the seed layer 121 and the buffer layer 120 disposed in the main element region MA, respectively.

The barrier layer 136 may be disposed on the sub-channel layer 132s. The barrier layer 136 may be disposed directly on the sub-channel layer 132s. However, it is not limited thereto, and another predetermined layer may be further positioned between the sub-channel layer 132s and the barrier layer 136. The region of the sub-channel layer 132s that overlaps the barrier layer 136 may be a drift region. For example, the barrier layer 136 is different from the sub-channel layer 132s in at least one of polarization characteristics, energy band gap, or lattice constant, and the two-dimensional electron gas 134 may be induced in the sub-channel layer 132s that is relatively less electrically polarized by the barrier layer 136.

In some implementations, in the peripheral circuit region PA, the sub-channel layer 132s may include the sub-drift region DTRs between the detection electrode SE and the sub-drain electrode 175s. For example, the sub-drift region DTRs may refer to a region of the sub-channel layer 132s from one side of the sub-channel layer 132s in contact with the sub-drain electrode 175s to the detection electrode SE. The sub-drift region DTRs may refer to a region of the sub-channel layer 132s that overlaps the barrier layer 136 between the detection electrode SE and the sub-drain electrode 175s. For example, the boundary where the sub-drain electrode 175s and the sub-channel layer 132s meet may be one edge of the sub-drift region DTRs, and the boundary where the detection electrode SE and the sub-channel layer 132s meet may be the other edge of the sub-drift region DTRs. For example, the sub-drift region DTRs may refer to a region where carriers move between the detection electrode SE and one side of the sub-channel layer 132s in contact with the sub-drain electrode 175s within the peripheral circuit region PA.

In some implementations, the sub-drift region DTRs may include a plurality of portions extending in the first direction (X direction) and a plurality of portions extending in a second direction (Y direction). For example, like the sub-channel layer 132s shown in FIG. 4, the sub-drift region DTRs may alternately have a portion extending in the first direction (X direction) and a portion extending in the second direction (Y direction) from one side of the sub-drain electrode 175s. This may be a shape to obtain a target length of sub-drift region DTRs in a unit area. However, this is only an example, and the extension direction of the sub-drift region DTRs is not limited thereto.

The sub-drift region DTRs may have a resistance component. For example, the sub-drift region DTRs may function as a resistance element (310 in FIG. 2) with a predetermined resistance value. For example, the region of the sub-channel layer 132s from the sub-drain electrode 175s to the detection electrode SE may have a predetermined resistance value.

The protective layer 140 may be disposed on the barrier layer 136. The lower surface of the protective layer 140 may be in contact with the barrier layer 136. In some implementations, the protective layer 140 is formed integrally with the protective layer 140 of the main element region MA through the same process. For example, the protective layer 140 may be disposed on the barrier layer 136 in the main element region MA and on the barrier layer 136 in the peripheral circuit region PA.

The sub-drain electrode 175s and the detection electrode SE may be disposed on one side and on the other side of the sub-channel layer 132s. The sub-drain electrode 175s and the detection electrode SE may be in contact with the sub-channel layer 132s and electrically connected to the sub-channel layer 132s. The sub-drain electrode 175s and the detection electrode SE may be disposed outside the sub-drift regions DTRs. The boundary surface between the sub-drain electrode 175s and the sub-channel layer 132s may be one edge of the sub-drift regions DTRs. Likewise, the boundary surface between the detection electrode SE and the sub-channel layer 132s may be the other edge of the sub-drift regions DTRs.

The sub-drain electrode 175s may extend from one end of the main drain electrode 175m in the second direction (Y direction). The sub-drain electrode 175s may refer to a portion of the drain electrode 175 disposed in the peripheral circuit region PA. The detection electrode SE may be an electrode corresponding to the third node (N3 in FIG. 2) to which the Zener unit 400 and the detector 500 are connected. Accordingly, the detection voltage Va may be transmitted to the Zener unit 400 and the detector 500 through the detection electrode SE.

In some implementations, the sub-drain electrode 175s and the detection electrode SE are disposed in a space where at least a portion of the sub-channel layer 132s is recessed. The sub-drain electrode 175s and the detection electrode SE may penetrate the barrier layer 136 and contact the side surface of the sub-channel layer 132s. The sub-drain electrode 175s and the detection electrode SE may be electrically connected to the sub-drift region DTRs. However, the arrangement is not limited thereto, and the sub-channel layer 132s may not be recessed, and the sub-drain electrode 175s and the detection electrode SE may be disposed on the upper surface of the sub-channel layer 132s.

The sub-drain electrode 175s and the detection electrode SE may cover at least a portion of the upper surface of the protective layer 140, but are not limited thereto. Additionally, the sub-drain electrode 175s and the detection electrode SE may cover at least a portion of the side surface of the protective layer 140. For example, the sub-drain electrode 175s and the detection electrode SE may cover the side surface of the protective layer 140. The upper surface of the sub-drain electrode 175s and the upper surface of the detection electrode SE may protrude from the upper surface of the protective layer 140.

In some implementations, the width of the detection electrode SE is substantially the same as the width of the sub-channel layer 132s. For example, as shown in FIG. 4, the width of the detection electrode SE in the first direction (X direction) may be substantially equal to the width of the sub-channel layer 132s in the first direction (X direction). However, the width is not limited thereto, and for example, the width of the detection electrode SE in the first direction (X direction) may be larger than the width of the sub-channel layer 132s in the first direction (X direction). In this case, the detection electrode SE may overlap the separation structure 160 in the third direction (Z direction), but the arrangement not limited thereto. As another example, the width of the detection electrode SE in the first direction (X direction) may be smaller than the width of the sub-channel layer 132s in the first direction (X direction).

The sub-drain electrode 175s and the detection electrode SE may include a conductive material. The sub-drain electrode 175s and the detection electrode SE may include the same material. For example, the sub-drain electrode 175s and the detection electrode SE may include the same material as the main source electrode 173m and the main drain electrode 175m. The sub-drain electrode 175s and the detection electrode SE may be formed by the same process as the sub-drain electrode 175s, the sub-source electrode 173s, the main source electrode 173m, and the main drain electrode 175m. For example, the detection electrode SE may include metal, metal alloy, conductive metal nitride, metal silicide, doped semiconductor material, conductive metal oxide, or conductive metal nitride. For example, the detection electrode SE may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The detection electrode (SE) may be made of a single layer or multiple layers. The detection electrode SE may be in ohmic contact with the sub-channel layer 132s. The region in contact with the detection electrode SE within the sub-channel layer 132s may be doped at a relatively high concentration compared to other regions, but is not limited thereto.

The sub-source electrode 173s may be disposed on the other side of the sub-channel layer 132s. The sub-source electrode 173s may be disposed to be spaced apart from the sub-channel layer 132s. For example, as shown in FIG. 4, the sub-source electrode 173s may be disposed to be spaced apart from the sub-channel layer 132s in the first direction (X direction). The sub-source electrode 173s may be electrically insulated from the sub-channel layer 132s. For example, the sub-source electrode 173s and the sub-channel layer 132s may be separated from each other by the separation structure 160. The sub-source electrode 173s may extend from one end of the main source electrode 173m in the second direction (Y direction). The sub-source electrode 173s may refer to a portion of the source electrode 173 disposed in the peripheral circuit region PA. In some implementations, the sub-source electrode 173s may include the same material as the sub-drain electrode 175s and the detection electrode SE. Additionally, the sub-source electrode 173s may include the same material as the main source electrode 173m. The sub-source electrode 173s may be formed integrally with the main source electrode 173m, the sub-drain electrode 175s, and the detection electrode SE in the same process.

In some implementations, the peripheral circuit element 300 is separated from the main transistor 100 by the separation structure 160. For example, a separation structure may be disposed between the peripheral circuit element 300 and the main transistor 100. The separation structure 160 may penetrate the barrier layer 136 and be recessed in at least a portion of the sub-channel layer 132s, but is not limited thereto. Accordingly, the sub-drift region DTRs of the peripheral circuit element 300 may be electrically insulated from the main transistor 100. However, the arrangement is not limited thereto, and as another example, the separation structure 160 may penetrate the barrier layer 136 and the sub-channel layer 132s. As another example, the peripheral circuit element 300 and the main transistor 100 may be separated by a trench penetrating at least a portion of the sub-channel layer 132s and/or the main channel layer 132m.

In some implementations, the separation structure 160 may contact the detection electrode SE. For example, as shown in FIG. 7, the separation structure 160 may contact one side of the detection electrode SE. However, the arrangement is not limited thereto, and as another example, as shown in FIG. 8, the barrier layer 136 may be further disposed between one side of the detection electrode SE and the separation structure 160.

In some implementations, the separation structure 160 is formed by forming the barrier layer 136 over the main channel layer 132m and the sub-channel layer 132s, and performing an ion implant process within the barrier layer 136 that is disposed between the main transistor 100 and the peripheral circuit element 300. For example, there may be no or little two-dimensional electron gas formed in the region of the sub-channel layer 132s that overlaps the region of the barrier layer 136 where the ion implant process was performed and the region of the sub-channel layer 132s in the third direction (Z direction). The ion implant region of the barrier layer 136 and the corresponding region of the sub-channel layer 132s may correspond to the separation structure 160. As another example, the separation structure 160 may be formed by performing an ion implant process on the sub-channel layer 132s. The ion implanted region in the sub-channel layer 132s may correspond to the separation structure 160. The material used in the ion implant process may be argon (Ar) ions. However, the separation structure's fabrication is not limited thereto, and, as another example, the separation structure 160 may be formed by forming the barrier layer 136 on the main channel layer 132m and the sub-channel layer 132s, forming a trench penetrating the barrier layer 136, and then filling the trench with an insulating material. The insulating material providing the separation structure 160 may include the same material as the protective layer 140. For example, the insulating material providing the separation structure 160 may include an oxide such as SiO₂ or Al₂O₃. As another example, the insulating material providing the separation structure 160 may include a nitride such as SiN or an oxynitride such as SiON. However, the material is not limited thereto, and the insulating material providing the separation structure 160 may include a material different from the protective layer 140. At least a portion of the main channel layer 132m and/or the sub-channel layer 132s may be recessed together.

As noted above, the semiconductor device may include the Zener unit 400 and the detector 500. Referring to FIG. 4, the Zener unit 400 and the detector 500 may be disposed outside the main element region MA and the peripheral circuit region PA. The Zener unit 400 and the detector 500 may be formed separately from the main transistor 100 and the peripheral circuit element 300 and may be disposed outside the main element region MA and the peripheral circuit region PA, but their arrangement is not limited thereto. For example, the Zener unit 400 may be formed integrally with the main transistor 100 and the peripheral circuit element 300 in the same process.

In some implementations, the Zener unit 400 may include a Zener diode (410 in FIG. 2). The Zener diode 410 may include a diode having a P-N junction structure. The Zener diode 410 may include a semiconductor material. For example, the Zener diode 410 may include silicon (Si), but is not limited thereto, and may include the same material as the sub-channel layer 132s. Hereinafter, a case in which the Zener unit 400 includes the Zener diode 410 will be described as an example.

The Zener diode 410 may be electrically connected between the resistance element 310 and the main transistor 100. For example, the Zener diode 410 may be electrically connected between the detection electrode SE and the sub-source electrode 173s. Accordingly, the Zener diode 410 may be electrically connected to the main source electrode 173m through the sub-source electrode 173s. For example, the anode (412 in FIG. 2) of the Zener diode 410 may be electrically connected to the main source electrode 173m through the sub-source electrode 173s, and the cathode 411 in FIG. 2 of the Zener diode 410 may be electrically connected to the detection electrode SE. The detector 500 may be electrically connected to the detection electrode SE. The detector 500 may detect a change in the voltage of one end of the main transistor 100 by detecting the voltage of the detection electrode SE.

The peripheral circuit element 300 of the semiconductor device may include the resistance element 310, and the Zener unit 400 may include the Zener diode 410. The detector 500 according to some implementations may detect the voltage of the detection electrode SE clipped by the Zener diode 410, and accordingly, detect a change in the voltage of one end of the main transistor 100.

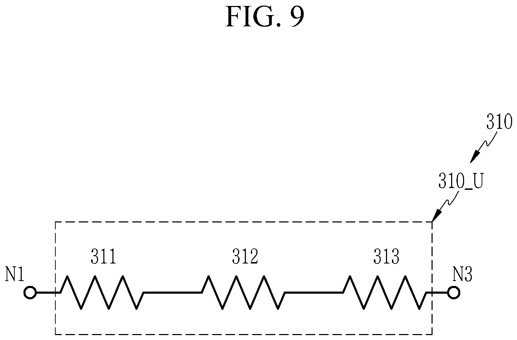

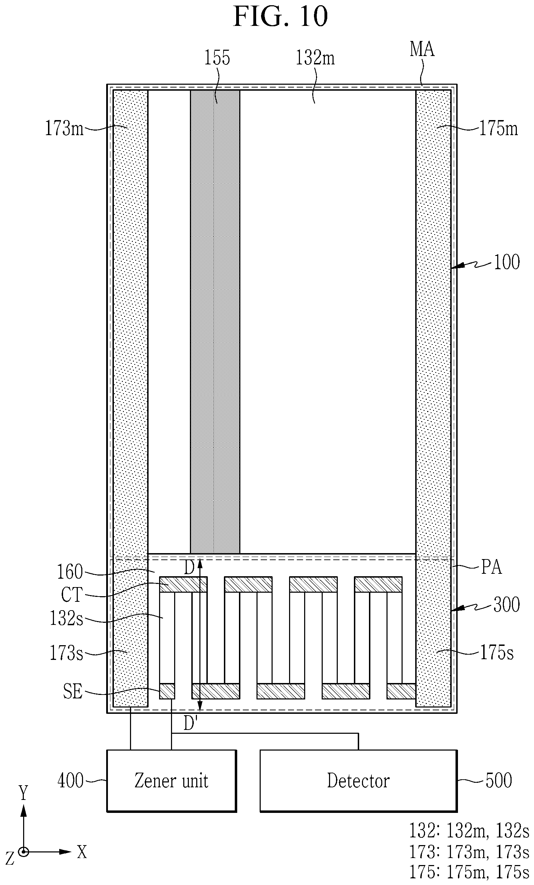

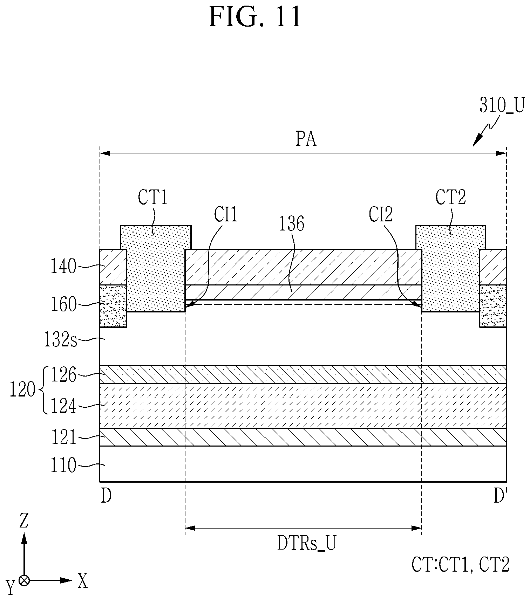

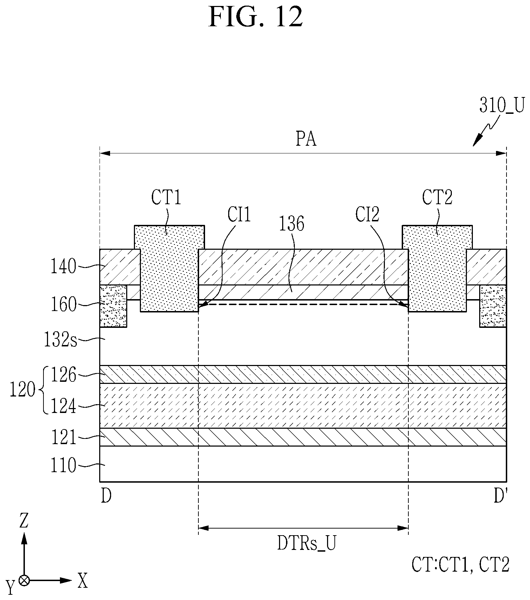

FIG. 9 is a circuit diagram illustrating a resistance unit of a semiconductor device according to some implementations. FIG. 10 is a top plan view illustrating the semiconductor device of FIG. 9. FIG. 11 is a cross-sectional view taken along line D-D' of FIG. 10. FIG. 12 is a cross-sectional view corresponding to line D-D' of FIG. 10 illustrating peripheral circuit elements of a semiconductor device according to some implementations. The peripheral circuit element 300 may correspond to the resistance element 310 of the example of FIG. 2. The resistance element 310 may include a plurality of resistance units 310_U of the example of FIG. 9. Hereinafter, a case where the peripheral circuit element 300 of a semiconductor device according to some implementations is the resistance element 310 including the plurality of resistance units 310_U will be described. Additionally, for better understanding and ease of description, FIG. 9 shows one resistance unit 310_U.

FIGS. 9 to 12 show various modifications of the semiconductor devices described with respect to FIGS. 1 to 8. Since the examples of FIGS. 9 to 12 are substantially similar to the examples of FIGS. 1 to 8, description of the same elements thereof will be omitted, and the differences will be mainly explained; characteristics of one apply equally to the other except where noted otherwise or suggested otherwise by context. In addition, the same reference numerals are used for the same components.

First, referring to FIG. 9, the resistance element 310 may include the plurality of resistance units 310_U. Each of the plurality of resistance units 310_U may include a resistance 312 in a sub-drift region (DTRs_U in FIG. 11), a first contact resistance 311, and a second contact resistance 313. Between the first node N1 and the third node N3, the resistance 312 in the sub-drift region (DTRs_U in FIG. 11), the first contact resistance 311, and the second contact resistance 313 may be connected in series. In some implementations, the first contact resistance 311 refers to the resistance of a first contact interface CI1 between a first contact electrode CT1 and the sub-channel layer 132s, and the second contact resistance 313 refers to the resistance of a second contact interface CI2 between a second contact electrode CT2 and the sub-channel layer 132s.

In some implementations, the resistance value of each of the plurality of resistance units 310_U has a constant value regardless of temperature. For example, the temperature coefficient of resistance (TCR) of each of the plurality of resistance units 310_U may be about 0. However, the temperature dependence is not limited thereto, the resistance value of each of the plurality of resistance units 310_U may increase or decrease as the temperature increases. In some implementations, the total sum of the resistance values of the plurality of resistance units 310_U has a constant value regardless of the temperature. As another example, the resistance value of each of the plurality of resistance units 310_U may increase or decrease as temperature increases.

Next, with further reference to FIGS. 10 and 11, the peripheral circuit element 300 of a semiconductor device may include the plurality of resistance units 310_U. Each of the plurality of resistance units 310_U may include the sub-channel layer 132s, the first contact electrode CT1, and the second contact electrode CT2.

The sub-channel layer 132s may be disposed between the first contact electrode CT1 and the second contact electrode CT2. The sub-channel layer 132s may extend in the second direction (Y direction), but the arrangement is not limited thereto. In some implementations, the sub-channel layer 132s includes the sub-drift region DTRs_U. The sub-drift region DTRs_U may function as an element having a predetermined resistance value. For example, the region of the sub-channel layer 132s from the first contact electrode CT1 to the second contact electrode CT2 may have a predetermined resistance value.

The resistance (312 in FIG. 9) of the sub-drift region DTRs_U may have different values depending on the temperature. For example, the resistance (312 in FIG. 9) of the sub-drift region DTRs_U may increase as the temperature increases. For example, the resistance (312 in FIG. 9) of the sub-drift region DTRs_U may have the temperature coefficient of resistance (TCR) of a positive sign. For example, the temperature coefficient of resistance of the sub-drift region DTRs_U may be about 5 (Ω/um°C) to about 15 (Ω/um°C). Accordingly, the resistance (312 in FIG. 9) of the sub-drift region DTRs_U may increase as the temperature increases.

The first contact electrode CT1 and the second contact electrode CT2 may be disposed on both sides of the sub-channel layer 132s. The first contact electrode CT1 and the second contact electrode CT2 may be in contact with the sub-channel layer 132s and electrically connected to the sub-channel layer 132s. The first contact electrode CT1 and the second contact electrode CT2 may be disposed outside the sub-drift region DTRs_U. The boundary surface between the first contact electrode CT1 and the sub-channel layer 132s may be one edge of the sub-drift region DTRs_U. Likewise, the boundary surface between the second contact electrode CT2 and the sub-channel layer 132s may be the other edge of the sub-drift region DTRs_U.

The first contact electrode CT1 and the second contact electrode CT2 may be disposed in a space where at least a portion of the sub-channel layer 132s is recessed. The first contact electrode CT1 and the second contact electrode CT2 may penetrate the barrier layer 136 and contact the side surface of the sub-channel layer 132s.

In some implementations, the first contact electrode CT1 and the second contact electrode CT2 contact the barrier layer 136. For example, one side surface of the first contact electrode CT1 and one side surface of the second contact electrode CT2 that face each other may be in contact with the barrier layer 136. Additionally, the other side surface opposite to one side surface of the first contact electrode CT1 and the other side surface opposite to one side surface of the second contact electrode CT2 may be in contact with the separation structure 160, but are not limited thereto. As another example, as shown in FIG. 12, the other side surface opposite to one side surface of the first contact electrode CT1 and the other side surface opposite to one side surface of the second contact electrode CT2 may also be in contact with the barrier layer 136. In this case, the barrier layer 136 may be further positioned between the separation structure 160 and the contact electrodes CT1 and CT2.

In some implementations, the first contact electrode CT1 and the second contact electrode CT2 are in ohmic contact with the sub-channel layer 132s. The first contact interface CI1 between the first contact electrode CT1 and the sub-channel layer 132s and the second contact interface CI2 between the second contact electrode CT2 and the sub-channel layer 132s may have a resistance component. For example, in the process where the carrier passing through the two-dimensional electron gas 134 passes at least a portion of the sub-channel layer 132s, e.g., the upper portion of the two-dimensional electron gas 134, and is transmitted to the detection electrode SE, the first contact interface CI1 between the first contact electrode CT1 and the sub-channel layer 132s and the second contact interface CI2 between the second contact electrode CT2 and the sub-channel layer 132s may have a predetermined resistance value. Hereinafter, for better comprehension and ease of description, the resistance of the first contact interface CI1 between the first contact electrode CT1 and the sub-channel layer 132s may correspond to the first contact resistance 311, and the resistance of the second contact interface CI2 between the second contact electrode CT2 and the sub-channel layer 132s may correspond to the second contact resistance 313.

In some implementations, the first contact resistance 311 and the second contact resistance 313 may have different values depending on temperature. For example, the first contact resistance 311 and the second contact resistance 313 may decrease as the temperature increases. For example, the first contact resistance 311 and the second contact resistance 313 may have the temperature coefficient of resistance (TCR) of a negative sign. For example, the temperature coefficient of resistance (TCR) of the first contact resistance 311 and the second contact resistance 313 may be about - 20 (Q/°C) to about -10 (Q/°C). In some implementations, the temperature coefficient of resistance (TCR) of the first contact resistance 311 and the second contact resistance 313 may be greater than the temperature coefficient of resistance of the sub-drift region DTRs_U, but are not limited thereto.

In some implementations, the sum of the first contact resistance 311, the second contact resistance 313, and the resistance 312 of the sub-drift region DTRs_U have a constant value regardless of temperature. However, the resistance is not limited thereto, and the sum of the first contact resistance 311, the second contact resistance 313, and the resistance 312 of the sub-drift region DTRs_U may increase or decrease as the temperature increases. In some implementations, the extension length of the sub-drift region DTRs_U may be 1 um to 10 um, and preferably 3 um to 4 um, length ranges which have been found to provide target resistance as a function of temperature characteristics.

The first contact electrode CT1 and the second contact electrode CT2 may be formed simultaneously in the same process as the detection electrode SE. The first contact electrode CT1 and the second contact electrode CT2 may be disposed on the same layer as the detection electrode SE. Additionally, the first contact electrode CT1 and the second contact electrode CT2 may include the same material as the detection electrode SE.

Hereinafter, examples of peripheral circuit elements will be described with reference to FIGS. 13 to 21.

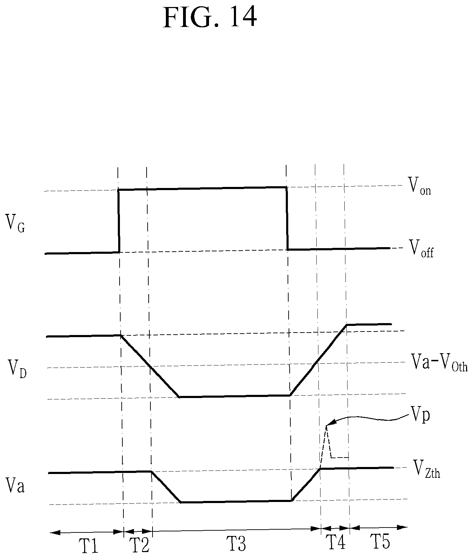

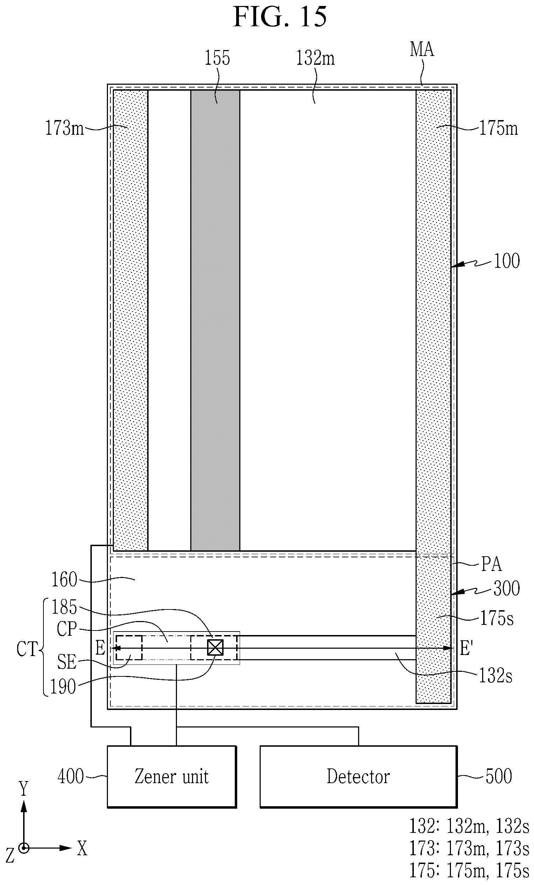

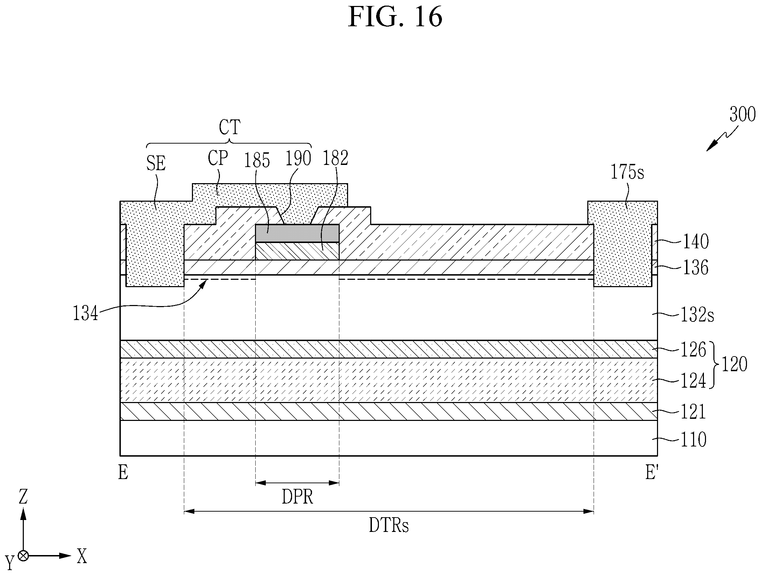

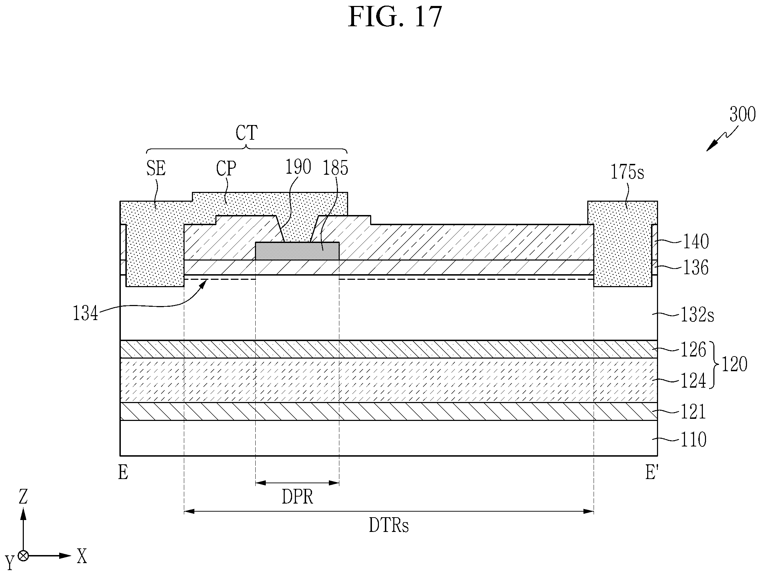

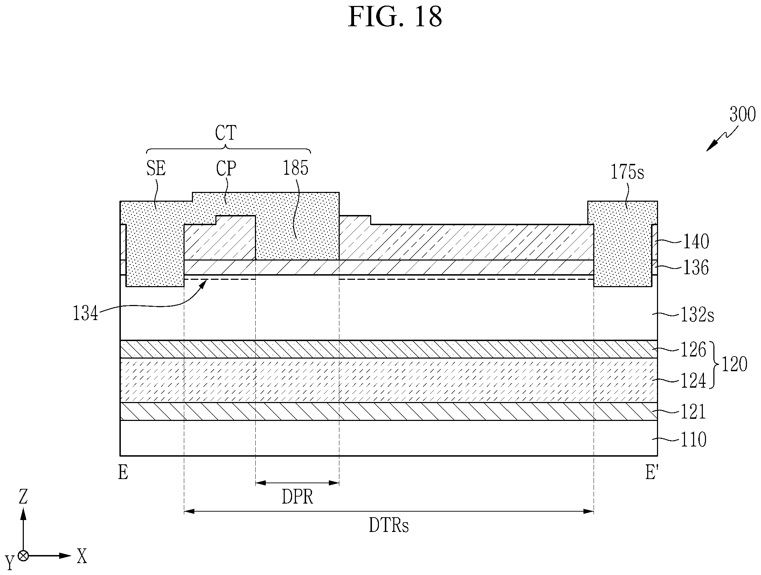

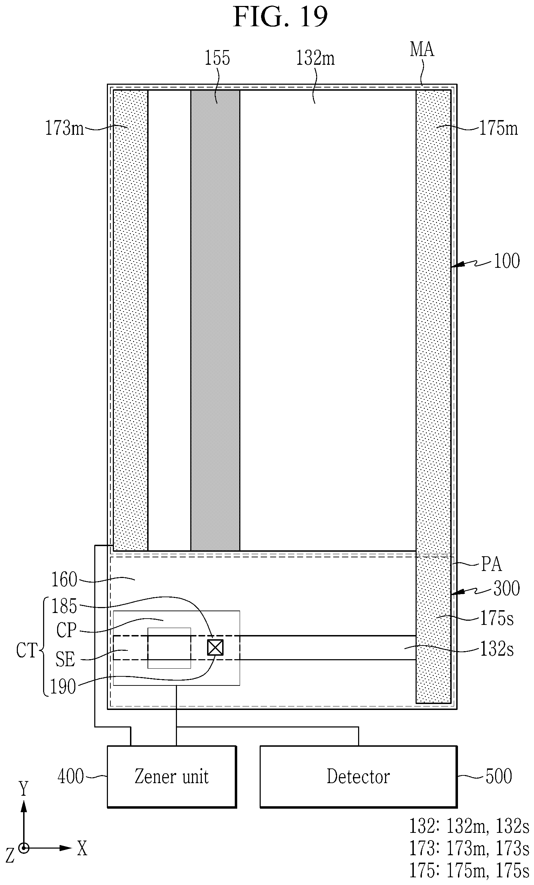

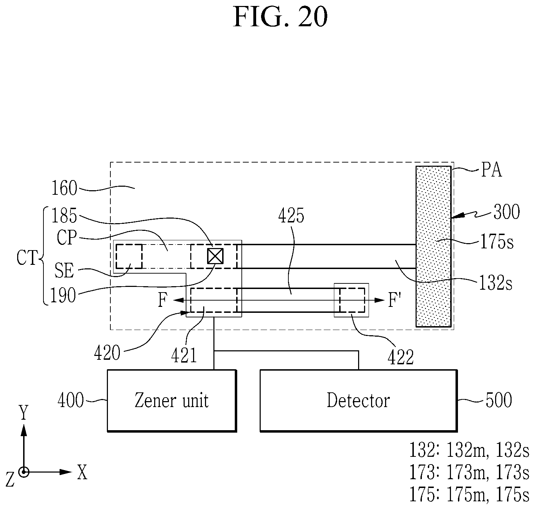

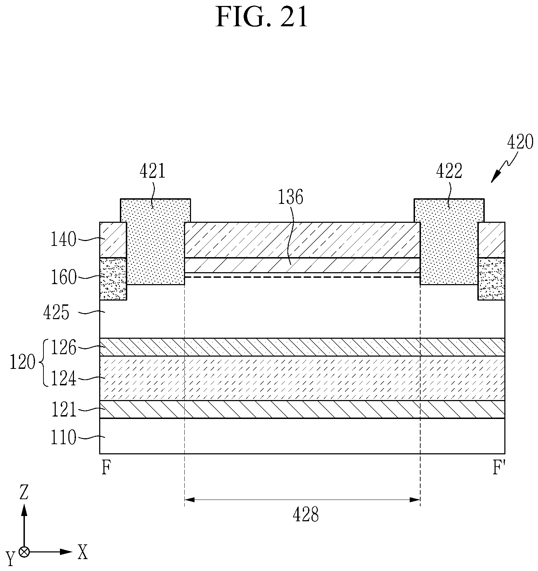

FIG. 13 is a circuit diagram illustrating a semiconductor device according to some implementations. FIG. 14 is a timing diagram illustrating the gate voltage, the first power voltage, and the detection voltage of the semiconductor device of FIG. 13. FIG. 15 is a top plan view illustrating a semiconductor device according to the example of FIG. 13. FIG. 16 is a cross-sectional view taken along line E-E' of FIG. 15. FIGS. 17 and 18 are cross-sectional views corresponding to E-E' of FIG. 15, illustrating peripheral circuit elements of a semiconductor device according to some implementations. FIG. 19 is a top plan view illustrating peripheral circuit elements of a semiconductor device according to some implementations. FIG. 20 is a cross-sectional view taken along line F-F' of FIG. 18. FIG. 21 is a top plan view illustrating a semiconductor device according to some implementations.

The peripheral circuit elements 300 of FIGS. 13 to 21 may correspond to the diode element 320 of the example of FIG. 13. Additionally, the Zener unit 400 of FIGS. 13 to 21 may correspond to the Zener diode 410 of the example of FIG. 13. Hereinafter, a case where the peripheral circuit element 300 of the semiconductor device according to some implementations includes the diode element 320 and the Zener unit 400 includes the Zener diode 410 will be described.

FIGS. 13 to 21 show various modifications of the semiconductor device according to some implementations shown in FIGS. 1 to 8. Since the examples of FIGS. 13 to 21 are substantially similar to the examples of FIGS. 1 to 8, similar description thereof will be omitted and the differences will be mainly explained. Characteristics of one are applicable to the other except where noted otherwise or suggested otherwise by context. In addition, the same reference numerals are used for the same components.

First, referring to FIG. 13, the peripheral circuit element 300 of a semiconductor device may include the diode element 320. The semiconductor device may include the diode element 320 and a detecting resistance element 420 that is electrically connected to the Zener diode 410.

The diode element 320 may be electrically connected to the first electrode D of the main transistor 100. Additionally, the diode element 320 may be electrically connected to the Zener diode 410 and the detector 500. For example, a cathode 321 of the diode element 320 may be connected to one end of the main transistor 100 through the first node N1. For example, the cathode 321 of the diode element 320 may be electrically connected to the first electrode D of the main transistor 100 through the first node N1. In some implementations, the cathode 321 of the diode element 320 is electrically connected to the main drain electrode (175m in FIG. 15) of the main transistor 100 through the first node N1. Additionally, the cathode 321 of the diode element 320 may be connected to a first power source having the first power voltage V_{D} through the first node N1. Accordingly, the first power voltage V_{D} may be supplied to the cathode 321 of the diode element 320. The anode 322 of the diode element 320 may be electrically connected to the Zener diode 410 and the detector 500 through the third node N3. In some implementations, the cathode 321 of the diode element 320 corresponds to the sub-drain electrode (175s in FIG. 15), and the anode 322 of the diode element 320 corresponds to the upper electrode (CT in FIG. 15). Additionally, the third node N3 may be a point corresponding to the detection electrode (SE in FIG. 15).

In some implementations, the diode element 320 may allow current to flow at a forward voltage greater than a threshold voltage V_{Oth}, but may not allow current to flow at a reverse voltage. Here, the forward direction may refer to the direction from the anode 322 of the diode element 320 to the cathode 321, and the reverse direction may refer to the direction from the cathode 321 of the diode element 320 to the anode 322. That is, when the value of the voltage applied to the anode 322 of the diode element 320 is greater than the sum of the value of the voltage applied to the cathode 321 and the value of the threshold voltage V_{Oth}, current may flow to into the diode element 320.

According to some implementations, the detection voltage Va may be applied to the anode 322 of the diode element 320, and the first power voltage V_{D} may be applied to the cathode 321 of the diode element 320. Therefore, when the value obtained by subtracting the value of the threshold voltage V_{Oth} from the value of the detection voltage Va (Va-V_{Oth}, hereinafter referred to as 'reference value') is greater than the first power voltage V_{D} (Va-V_{Oth} > V_{D}), current may flow along a third path C3. Additionally, if the reference value is smaller than the first power voltage V_{D} (Va-V_{Oth} < V_{D}), current may not flow into the diode element 320. The threshold voltage V_{Oth} of the diode element 320 may be greater than the breakdown voltage V_{Zth} of the Zener diode 410, but is not limited thereto. For example, the threshold voltage V_{Oth} of the diode element 320 may be smaller than the breakdown voltage V_{Zth} of the Zener diode 410. According to such characteristics, the diode element 320 may perform clipping of the detection voltage Va of the third node N3. This will be described with reference to FIG. 14.

The detecting resistance element 420 may be electrically connected to the diode element 320. One end of the detecting resistance element 420 may be electrically connected to the anode 322 of the diode element 320 through the third node N3. Additionally, one end of the detecting resistance element 420 may be electrically connected to the detector 500 and the cathode 411 of the Zener diode 410 through the third node N3. The other end of the detecting resistance element 420 may be electrically connected to a third power that supplies a third power voltage V_{DC}. The third power voltage V_{DC} may be greater than the breakdown voltage V_{Zth} of the Zener diode 410.

In some implementations, the detector 500 detects the detection voltage Va of the third node N3. The detector 500 may detect a change in voltage at one end of the main transistor 100 based on the detection voltage Va. For example, the detector 500 may detect the time period where the value of the first power voltage V_{D} is less than the difference between the detection voltage Va of the third node N3 and the threshold voltage V_{Oth} of the diode element 320, based on the detection voltage Va. As another example, the detector 500 may detect a change in the first power voltage V_{D} based on the detection voltage Va and calculate a time period in which the main transistor 100 is turned on.

Referring further to FIG. 14, the value of the first power voltage V_{D} in the first time period T1 and the second time period T2 may be greater than the reference value Va-V_{Oth}. This is a case where a reverse voltage is applied to the diode element 320, and current may not flow into the diode element 320. For example, current may not flow along the third path C3. Meanwhile, the third power voltage V_{DC} may be greater than the breakdown voltage V_{Zth} of the Zener diode 410, and accordingly, the value of the detection voltage Va may be greater than the breakdown voltage V_{Zth} of the Zener diode 410. This is a case where a reverse voltage greater than the breakdown voltage V_{Zth} is applied to the Zener diode 410, and current may flow into the Zener diode 410. For example, current may flow along the fourth path C4. Accordingly, the detection voltage Va in the first time period T1 and the second time period T2 may be substantially equal to the breakdown voltage V_{Zth} of the Zener diode 410.

Additionally, the value of the first power voltage V_{D} in the third time period T3 may be smaller than the reference value Va-V_{Oth}. This is a case where a forward voltage is applied to the diode element 320, and current may flow into the diode element 320. For example, current may flow along the third path C3. For example, current may pass from the third power voltage V_{DC} to the third node N3 through the detecting resistance element 420 and to the first node N1 through the diode element 320. Accordingly, the voltage over the detecting resistance element 420 may drop and the detection voltage Va may decrease.

Accordingly, as the detection voltage Va decreases, the value of the detection voltage Va may become smaller than the breakdown voltage V_{Zth} of the Zener diode 410. This is the case where a reverse voltage smaller than the breakdown voltage V_{Zth} is applied to the Zener diode 410, such that current may not flow into the Zener diode 410. Accordingly, in the third time period T3, the detection voltage Va may change similarly to the profile in which the first power voltage V_{D} changes.

Additionally, the value of the first power voltage V_{D} in the fourth time period T4 and the fifth time period T5 may be greater than the reference value Va-V_{Oth}. This is a case where a reverse voltage is applied to the diode element 320, and current may not flow in the diode element 320. Additionally, current may flow into the Zener diode 410.

Meanwhile, the starting point of the fourth time period T4 may be a point where the diode element 320 is turned off. For example, while the current flows along the third path C3, the diode element 320 may be turned off at the starting point of the fourth time period T4 as the first power voltage V_{D} increases. At this time, a peak voltage V_{P} may occur at both ends of the diode element 320. For example, the peak voltage V_{P} may be supplied to the third node N3. Here, the peak voltage V_{P} may mean a transient voltage due to a ringing phenomenon. In some implementations, even when the peak voltage V_{P} is supplied to the third node N3, the peak voltage V_{P} is greater than the breakdown voltage V_{Zth} of the Zener diode 410, so the detection voltage Va of the third node N3 may be maintained at a certain level (for example, the value of the breakdown voltage V_{Zth}) by the Zener diode 410. In summary, depending on the value of the first power voltage V_{D} and the value of the difference between the detection voltage Va of the third node N3 and the threshold voltage V_{Oth} of the diode element 320, the value of the detection voltage Va of the third node N3 may change. The detector 500 may detect a case where the detection voltage Va of the third node N3 is outside the range of the predetermined first power voltage V_{D}. For example, the detector 500 may detect the case where the voltage applied to one end of the main transistor 100 of the semiconductor device is outside a predetermined range.

Next, the peripheral circuit element 300 will be described with reference to FIGS. 15 to 19. The peripheral circuit element 300 may correspond to the diode element 320 of FIG. 13. Hereinafter, a case where the peripheral circuit element 300 of the semiconductor device is the diode element 320 will be described.

Referring to FIGS. 15 to 19, the peripheral circuit element 300 may include the sub-channel layer 132s connected to the main drain electrode 175m and including a drift region with two-dimensional electron gas, the barrier layer 136 disposed on the sub-channel layer 132s, a sub-gate electrode 185 disposed on the barrier layer 136, and the detection electrode SE and the sub-drain electrode 175s spaced apart from each other on the sub-channel layer 132s.

The sub-channel layer 132s may extend in the first direction (X direction). For example, as shown in FIG. 15, the sub-channel layer 132s may extend from one side of the sub-drain electrode 175s in the first direction (X direction). However, this is only an example, and the sub-channel layer 132s may, for example, further include a portion extending in a direction intersecting the first direction (X direction) or may include a plurality of bent portions. In some implementations, one end of the sub-channel layer 132s contacts the sub-drain electrode 175s. The sub-channel layer 132s may be electrically connected to the main drain electrode 175m through the sub-drain electrode 175s.

The sub-gate electrode 185 may be disposed on the barrier layer 136. The sub-gate electrode 185 may overlap a portion of the barrier layer 136 in the vertical direction (e.g., the thickness direction of the sub-channel layer 132s). The sub-gate electrode 185 may overlap a portion of the sub-drift regions DTRs of the sub-channel layer 132s in a vertical direction (e.g., in the thickness direction of the sub-channel layer 132s). The sub-gate electrode 185 may be disposed between the detection electrode SE and the sub-drain electrode 175s. The sub-gate electrode 185 may be spaced apart from the detection electrode SE and the sub-drain electrode 175s. For example, the sub-gate electrode 185 may be disposed closer to the detection electrode SE than the sub-drain electrode 175s. For example, the separation distance between the sub-gate electrode 185 and the detection electrode SE may be less than the separation distance between the sub-gate electrode 185 and the sub-drain electrode 175s, but is not limited thereto.

The sub-gate electrode 185 may include a conductive material. The sub-gate electrode 185 may include the same material as the main gate electrode 155. In some implementations, the sub-gate electrode 185 is formed simultaneously with the main gate electrode 155 in the same process. The sub-gate electrode 185 may be disposed on the same layer as the main gate electrode 155. For example, the sub-gate electrode 185 may be disposed on the sub-gate semiconductor layer 182, and the main gate electrode 155 may be disposed on the gate semiconductor layer 152. The lower surface of the sub-gate electrode 185 may be disposed at substantially the same level as the lower surface of the main gate electrode 155. The thickness of the sub-gate electrode 185 along the third direction (Z-direction) may be substantially the same as the thickness of the main gate electrode 155 along the third direction (Z direction).

However, the present disclosure is not limited to the prior arrangements, and the sub-gate electrode 185 may be disposed on a different layer from the main gate electrode 155. For example, as shown in FIG. 17, the sub-gate electrode 185 may be disposed directly on the upper surface of the barrier layer 136. For example, the sub-gate semiconductor layer 182 may not be disposed between the sub-gate electrode 185 and the barrier layer 136. The sub-gate electrode 185 may contact the upper surface of the barrier layer 136.

As another example, as shown in FIG. 18, the sub-gate electrode 185 may be formed integrally with the detection electrode SE in the same process. The sub-gate electrode 185 may include the same material as the detection electrode SE, but is not limited thereto, and the sub-gate electrode 185 may include a different material from the detection electrode SE. The sub-gate electrode 185 may be disposed directly on the upper surface of the barrier layer 136, but is not limited thereto. The sub-gate semiconductor layer 182 may be further disposed on the upper surface of the barrier layer 136, and the sub-gate electrode 185 may be disposed on the sub-gate semiconductor layer 182.

The sub-gate semiconductor layer 182 may be disposed between the barrier layer 136 and the sub-gate electrode 185. For example, the sub-gate semiconductor layer 182 may be disposed on the barrier layer 136, and the sub-gate electrode 185 may be disposed on the sub-gate semiconductor layer 182. The sub-gate electrode 185 may be in Schottky contact or ohmic contact with the sub-gate semiconductor layer 182. The sub-gate semiconductor layer 182 may overlap the sub-gate electrode 185 in a vertical direction (e.g., the thickness direction of the sub-channel layer 132s).

Additionally, the peripheral circuit element 300 of the semiconductor device may further include a connection portion CP and a through via 190. The connection portion CP may extend from one side of the detection electrode SE along a first direction. The connection portion CP may be disposed on the protective layer 140. The connection portion CP may cover the upper surface of the protective layer 140. The connection portion CP may cover at least a portion of the sub-gate electrode 185. The connection portion CP may overlap the sub-channel layer 132s in the third direction (Z direction), but is not limited thereto. The through via 190 may penetrate the protective layer 140 and be connected to the sub-gate electrode 185. The through via 190 may electrically connect the connection portion CP and the sub-gate electrode 185.

In some implementations, the detection electrode SE is formed integrally with the connection portion CP and the through via 190, but the present disclosure is not limited thereto. For example, the detection electrode SE may be formed integrally with the connection portion CP and the through via 190 in the same process.

The connection portion CP may have various shapes. For example, as shown in FIG. 16, the connection portion CP may extend in the first direction (X direction). As another example, as shown in FIG. 19, the connection portion CP may further include a portion extending in a direction intersecting the first direction (X direction). The connection portion CP may include a portion extending in the second direction (Y direction) and a portion extending in the first direction (X direction) from the point where the connection portion CP meets the detection electrode SE, and a portion extending in the second direction (Y direction) from the point where the connection portion CP meets the through via 190. The connection portion CP may overlap the separation structure 160 in the third direction (Z direction). As another example, the connection portion CP may include a plurality of bent portions and/or may have a curved shape.

Accordingly, the detection electrode SE may be electrically connected to the sub-gate electrode 185 through the connection portion CP and the through via 190. Accordingly, the peripheral circuit element 300 may function as the diode element 320 of FIG. 13. For example, the upper electrode CT including the detection electrode SE, sub-gate electrode 185, connection portion CP, and through via 190 may be the anode 322 of the diode element 320 in FIG. 13. The sub-drain electrode 175s may be the cathode 321 of the diode element 320 of FIG. 13.

Referring to FIGS. 20 and 21, the detecting resistance element 420 of a semiconductor device may be disposed within the peripheral circuit region PA.

The detecting resistance element 420 of a semiconductor device may include a channel pattern 425, a first electrode 421, and a second electrode 422.

The channel pattern 425 may extend in the first direction (X direction). For example, the channel pattern 425 may extend in the same direction as the sub-channel layer 132s, but is not limited thereto. The remaining description of the channel pattern 425 will be omitted since it is substantially the same as the description of the sub-channel layer 132s.

In some implementations, the barrier layer 136 may extend over the channel pattern 425. Accordingly, the region of the channel pattern 425 that overlaps the barrier layer 136 may become a drift region. The channel pattern 425 may include a first drift region 428 between the first electrode 421 and the second electrode 422. For example, the first drift region 428 may mean a region of the channel pattern 425 from one side of the channel pattern 425 in contact with the second electrode 422 to the first electrode 421. The first drift region 428 may refer to a region of the channel pattern 425 that overlaps the barrier layer 136 between the first electrode SE and the second electrode 422. For example, the interface where the second electrode 422 and the channel pattern 425 meet may be one edge of the first drift region 428, and the boundary where the first electrode 421 and the channel pattern 425 meet may be the other edge of the first drift region 428. For example, the first drift region 428 may mean a region where carriers move between the first electrode 421 and one side of the channel pattern 425 that is in contact with the second electrode 422.

The first drift region 428 may have a resistance component. For example, the first drift region 428 may function as a detecting resistance element (420 in FIG. 13) with a predetermined resistance value. For example, the region of the channel pattern 425 from the first electrode 421 to the second electrode 422 may have a predetermined resistance value.

The first electrode 421 and the second electrode 422 may penetrate the protective layer 140 and the barrier layer 136 and contact the channel pattern 425. In some implementations, the first electrode 421 is electrically connected to the detection electrode SE. The first electrode 421 may be electrically connected to the Zener unit 400 and the detector 500. The second electrode 422 may be electrically connected to the third power source that supplies the third power voltage V_{DC}. The first electrode 421 and the second electrode 422 may be formed simultaneously in the same process as the detection electrode SE, but their fabrication is not limited thereto.

In the examples of FIGS. 20 and 21, the detecting resistance element 420 is described as being disposed within the peripheral circuit region PA, but the present disclosure is not limited thereto. For example, the detecting resistance element 420 may be disposed within the Zener unit 400. Alternatively, the detecting resistance element 420 may be disposed within the detector 500.

Hereinafter, examples of peripheral circuit elements will be described with reference to FIGS. 22 to 25.

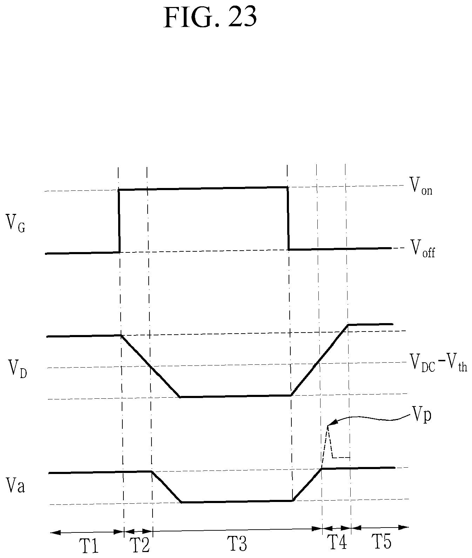

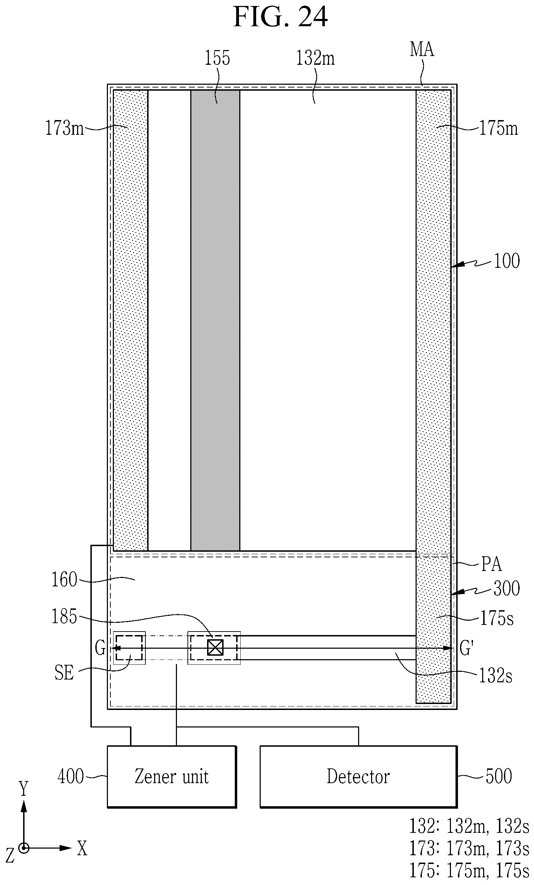

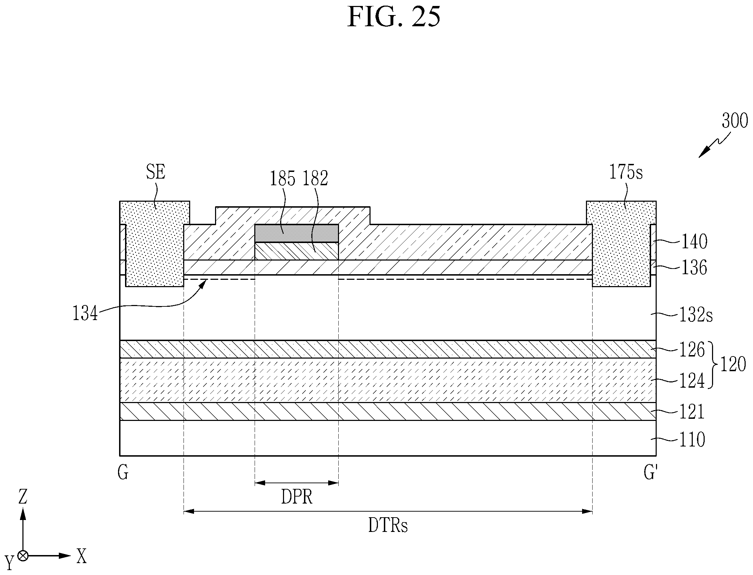

FIG. 22 is a circuit diagram illustrating a semiconductor device according to some implementations. FIG. 23 is a timing diagram illustrating the gate voltage, the first power voltage, and the detection voltage of the semiconductor device according to the example of FIG. 22. FIG. 24 is a top plan view illustrating the semiconductor device of FIG. 22. FIG. 25 is a cross-sectional view taken along line G-G' of FIG. 24.

The peripheral circuit element 300 of the semiconductor device according to the examples of FIGS. 22 to 25 may correspond to the sub-transistor element 330 of the example of FIG. 22. Additionally, the Zener unit 400 of the semiconductor device according to the examples of FIGS. 22 to 25 may correspond to the Zener diode 410 of the example of FIG. 22. Hereinafter, a case where the peripheral circuit element 300 includes the sub-transistor element 330 and the Zener unit 400 includes the Zener diode 410 will be described.

FIGS. 22 to 25 show various modifications of the semiconductor devices shown in FIGS. 13 to 21. Since the example of FIGS. 22 to 25 is substantially similar to the examples of FIGS. 13 to 21, description thereof will be omitted and the differences will be mainly explained. Characteristics of one apply equally to the other except where noted otherwise or suggested otherwise by context. In addition, the same reference numerals are used for the same components.

First, referring to FIG. 22, the peripheral circuit element 300 may include the sub-transistor element 330.

The sub-transistor element 330 may be electrically connected to the first electrode D of the main transistor 100. Additionally, the sub-transistor element 330 may be electrically connected to the Zener diode 410 and the detector 500. The sub-transistor element 330 may include a gate electrode G1, a first electrode, and a second electrode. The sub-transistor element 330 may control the drain-source current between the first electrode and the second electrode according to the signal applied to the gate electrode G1. A sub-gate voltage V_{G1} may be supplied to the gate electrode G1 of the sub-transistor element 330. The first electrode of the sub-transistor element 330 may be connected to the first electrode D of the main transistor 100 through the first node N1. Additionally, the first electrode of the sub-transistor element 330 may be connected to the first power source having a first power voltage V_{D} through the first node N1. Accordingly, the first power voltage V_{D} may be supplied to the first electrode of the sub-transistor element 330. The second electrode of the sub-transistor element 330 may be electrically connected to the Zener diode 410 and the detector 500 through the third node N3. In some implementations, the first electrode of the sub-transistor element 330 may correspond to the sub-drain electrode (175s in FIG. 24), and the gate electrode G1 of the sub-transistor element 330 may correspond to the sub-gate electrode (185 in FIG. 24). Additionally, the third node N3 may be a point corresponding to the detection electrode (SE in FIG. 24).

In some implementations, the detector 500 may detect the detection voltage Va of the third node N3. The detector 500 may detect a change in voltage at one end of the main transistor 100 based on the detection voltage Va. For example, the detector 500 may detect the time period where the value of the first power voltage V_{D} is less than the difference between the sub-gate voltage V_{G1} and the threshold voltage of the sub-transistor element 330, based on the detection voltage Va.

Further referring to FIG. 23, the value of the first power voltage V_{D} in the first time period T1 and the second time period T2 may be greater than the difference between the sub-gate voltage and the threshold voltage of the sub-transistor element 330(see reference symbol 'V_{G1}-Vₜₕ' in FIG. 23). This is a case in which the sub-transistor element 330 is turned off, and current may not flow into the sub-transistor element 330. The detection voltage Va of the third node N3 may have a predetermined value.

Additionally, the value of the first power voltage V_{D} in the third time period T3 may be smaller than the difference between the sub-gate voltage and the threshold voltage of the sub-transistor element 330(see reference symbol 'V_{G1}-Vₜₕ' in FIG. 23). This is when the sub-transistor element 330 is turned on, and current may flow into the sub-transistor element 330. At this time, when the detection voltage Va at the third node N3 is smaller than the breakdown voltage V_{Zth} of the Zener diode 410, current may not flow into the Zener diode 410. Accordingly, in the third time period T3, the detection voltage Va may change similarly to the profile in which the first power voltage V_{D} changes. However, the present disclosure is not limited thereto, and the detection voltage Va at the third node N3 may be greater than the breakdown voltage V_{Zth} of the Zener diode 410. In this case, the current may flow along a fifth path C5, and the value of the detection voltage Va of the third node N3 may be substantially the same as the value of the breakdown voltage V_{Zth} of the Zener diode 410.

In addition, the value of the first power voltage V_{D} in the fourth time period T4 and the fifth time period T5 may be greater than the difference between the sub-gate voltage and the threshold voltage of the sub-transistor element 330(see reference symbol 'V_{G1}-Vₜₕ' in FIG. 23). At this time, current may not flow through the sub-transistor element 330.

Meanwhile, the starting point of the fourth time period T4 may be a point where the sub-transistor element 330 is turned off. For example, as the first power voltage V_{D} increases, the sub-transistor element 330 may be turned off at the starting point of the fourth time period T4. At this time, the peak voltage V_{P} may occur at both ends of the sub-transistor element 330. For example, the peak voltage V_{P} may be supplied to the third node N3. Here, the peak voltage V_{P} may mean a transient voltage due to a ringing phenomenon. In some implementations, when the peak voltage V_{P} is supplied to the third node N3, the peak voltage V_{P} is greater than the breakdown voltage V_{Zth} of the Zener diode 410, so the current may flow into the Zener diode 410 through the fifth path C5, and the detection voltage Va of the third node N3 may be substantially equal to the breakdown voltage V_{Zth} of the Zener diode 410. For example, even when the peak voltage V_{P} is supplied to the third node N3, the value of the detection voltage Va of the third node N3 may be maintained constant by the Zener diode 410.

In summary, depending on the value of the first power voltage V_{D} and the value of the difference between the sub-gate voltage and the threshold voltage of the sub-transistor element 330(see reference symbol 'V_{G1}-Vₜₕ' in FIG. 23), the value of the detection voltage Va of the third node N3 may change. The detector 500 may detect a case where the detection voltage Va of the third node N3 is outside the range of the predetermined first power voltage V_{D}. For example, the detector 500 may detect the case where the voltage applied to one end of the main transistor 100 of the semiconductor device is outside a predetermined range.

Next, the peripheral circuit element 300 will be described with reference to FIGS. 24 and 25. The peripheral circuit element 300 may correspond to the sub-transistor element 330 of FIG. 22. Hereinafter, a case where the peripheral circuit element 300 is the sub-transistor element 330 will be described.

Referring to FIGS. 24 and 25, the peripheral circuit element 300 of the semiconductor device may include the sub-channel layer 132s connected to the main drain electrode 175m and including a drift region with a two-dimensional electron gas, the barrier layer 136 disposed on the sub-channel layer 132s, a sub-gate electrode 185 disposed on the barrier layer 136, and the detection electrode SE and the sub-drain electrode 175s spaced apart from each other on the sub-channel layer 132s.

The sub-channel layer 132s may extend in the first direction (X direction). For example, as shown in FIG. 24, the sub-channel layer 132s may extend from one side of the sub-drain electrode 175s in the first direction (X direction). However, this is only an example, and the sub-channel layer 132s may, for example, further include a portion extending in a direction intersecting the first direction (X direction) or may include a plurality of bent portions. In some implementations, one end of the sub-channel layer 132s may contact the sub-drain electrode 175s. The sub-channel layer 132s may be electrically connected to the main drain electrode 175m through the sub-drain electrode 175s.

The sub-gate electrode 185 may be disposed on the barrier layer 136. The sub-gate electrode 185 may correspond to the gate electrode (G1 in FIG. 22) of the sub-transistor element (330 in FIG. 22). The sub-gate semiconductor layer 182 may be disposed between the barrier layer 136 and the sub-gate electrode 185. The description of the sub-gate electrode 185 and the sub-gate semiconductor layer 182 is substantially the same as the description of the sub-gate electrode 185 and the sub-gate semiconductor layer 182 of the examples of FIGS. 13 to 21, and will therefore be omitted.

The detection electrode SE may correspond to the second electrode of the sub-transistor element (330 in FIG. 22), and the sub-drain electrode 175s may correspond to the second electrode of the sub-transistor element (330 in FIG. 22).

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
Clause 1. A semiconductor device, comprising: a main transistor; a peripheral circuit element electrically connected to a first source or drain of the main transistor; and a Zener diode electrically connected between a second source or drain of the main transistor and the peripheral circuit element, wherein the main transistor comprises: a main channel layer, a barrier layer on the main channel layer and including a material having an energy band gap different from an energy band gap of the main channel layer, a main gate electrode on the barrier layer, a gate semiconductor layer arranged between the barrier layer and the main gate electrode, and a main source electrode and a main drain electrode disposed on respective sides of the main gate electrode and electrically connected to the main channel layer, wherein the peripheral circuit element comprises: a sub-channel layer electrically connected to the main drain electrode and including a drift region having a two-dimensional electron gas; and a detection electrode on the sub-channel layer, and wherein the Zener diode is electrically connected between the detection electrode and the main source electrode.
Clause 2. The semiconductor device of clause 1, wherein: the peripheral circuit element comprises a sub-drain electrode electrically connected to the sub-channel layer, and the sub-drain electrode is disposed on a same layer as the main drain electrode.
Clause 3. The semiconductor device of clause 1 or 2, wherein the peripheral circuit element comprises a sub-source electrode electrically connected to the main source electrode and spaced apart from the sub-channel layer, wherein the sub-source electrode is disposed on a same layer as the main source electrode, and wherein the sub-channel layer is disposed on a same layer as the main channel layer.
Clause 4. The semiconductor device of any preceding clause, wherein: an anode of the Zener diode is electrically connected to the main source electrode, and a cathode of the Zener diode is electrically connected to the detection electrode.
Clause 5. The semiconductor device of any preceding clause, wherein a width of the sub-channel layer is smaller than a width of the main channel layer.
Clause 6. The semiconductor device of any preceding clause, wherein the peripheral circuit element comprises a resistance element, the resistance element including a resistance of the drift region of the sub-channel layer between the main drain electrode and the detection electrode.
Clause 7. The semiconductor device of clause 6, wherein the resistance element comprises a contact electrode on the sub-channel layer and arranged between the detection electrode and the main drain electrode.
Clause 8. The semiconductor device of clause 7, wherein the contact electrode is disposed on a same layer as the detection electrode and comprises a same material as the detection electrode.
Clause 9. The semiconductor device of any preceding clause, wherein the peripheral circuit element comprises: a sub-drain electrode electrically connected to the sub-channel layer and disposed on a same layer as the main drain electrode; and a sub-gate electrode on the sub-channel layer and arranged between the detection electrode and the sub-drain electrode.
Clause 10. The semiconductor device of clause 9, wherein the sub-gate electrode is disposed on a same layer as the main gate electrode and comprises a same material as the main gate electrode.
Clause 11. The semiconductor device of clause 9 or 10, wherein the peripheral circuit element comprises a diode element comprising the sub-gate electrode, wherein the sub-gate electrode is electrically connected to the detection electrode, and wherein a breakdown voltage of the Zener diode is smaller than a threshold voltage of the diode element.
Clause 12. The semiconductor device of clause 9, 10 or 11, wherein: the barrier layer extends above the sub-channel layer, and the barrier layer is arranged between the sub-channel layer and the sub-gate electrode.
Clause 13. The semiconductor device of clause 12, wherein the peripheral circuit element comprises a sub-gate semiconductor layer arranged between the barrier layer and the sub-gate electrode.
Clause 14. The semiconductor device of clause 12 or 13, wherein the peripheral circuit element comprises: a protective layer covering the barrier layer; and a connection portion on the protective layer and connecting the sub-gate electrode with the detection electrode.
Clause 15. The semiconductor device of any preceding clause, further comprising a separation structure arranged on the sub-channel layer between the peripheral circuit element and the main transistor, the separation structure extending into the barrier layer.
Clause 16. A semiconductor device, comprising: a main transistor; a resistance element electrically connected to a first source or drain of the main transistor; and a Zener diode electrically connected between a second source or drain of the main transistor and the resistance element, wherein the main transistor comprises: a main channel layer, a barrier layer on the main channel layer and including a material having an energy band gap different from an energy band gap of the main channel layer, a gate electrode disposed on the barrier layer, a gate semiconductor layer arranged between the barrier layer and the gate electrode, and a main source electrode and a main drain electrode disposed on respective sides of the gate electrode and electrically connected to the main channel layer, wherein the resistance element comprises: a sub-channel layer electrically connected to the main drain electrode and including a drift region having a two-dimensional electron gas, a sub-drain electrode electrically connected to a first side of the sub-channel layer and extending from one end of the main drain electrode, and a detection electrode electrically connected to a second side of the sub-channel layer, wherein a width of the sub-channel layer is smaller than a width of the main channel layer, and wherein the Zener diode is electrically connected between the detection electrode and the main source electrode.
Clause 17. The semiconductor device of clause 16, wherein: the barrier layer extends above the sub-channel layer, and the sub-drain electrode and the detection electrode extend into the barrier layer.
Clause 18. A semiconductor device, comprising: a main transistor; a sub-transistor element electrically connected to a first source or drain of the main transistor; and a Zener diode electrically connected between a second source or drain of the main transistor and the sub-transistor element, wherein the main transistor comprises a main channel layer, a barrier layer on the main channel layer and including a material having an energy band gap different from an energy band gap of the main channel layer, a gate electrode on the barrier layer, a gate semiconductor layer arranged between the barrier layer and the gate electrode, and a main source electrode and a main drain electrode disposed on respective sides of the gate electrode and electrically connected to the main channel layer, wherein the sub-transistor element comprises: a sub-channel layer electrically connected to the main drain electrode and including a drift region having a two-dimensional electron gas, a sub-drain electrode electrically connected to the sub-channel layer and extending from one end of the main drain electrode, a detection electrode electrically connected to the sub-channel layer, and a sub-gate electrode on the sub-channel layer and arranged between the sub-drain electrode and the detection electrode, and wherein the Zener diode is electrically connected between the detection electrode and the main source electrode.
Clause 19. The semiconductor device of clause 18, wherein a threshold voltage of the sub-transistor element is greater than a breakdown voltage of the Zener diode.
Clause 20. The semiconductor device of clause 18 or 19, wherein the barrier layer extends above the sub-channel layer, and wherein the sub-transistor element comprises: a protective layer covering the barrier layer and the sub-gate electrode; and a connection portion on the protective layer and electrically connecting the sub-gate electrode with the detection electrode.

While the examples of the present disclosure have been described in detail, it is to be understood that the disclosure is not limited to the disclosed examples, but on the contrary, is intended to cover various modifications and equivalent arrangements.

## Claims

1. A semiconductor device, comprising:
a main transistor;
a peripheral circuit element electrically connected to a first source or drain of the main transistor; and
a Zener diode electrically connected between a second source or drain of the main transistor and the peripheral circuit element,
wherein the main transistor comprises:
a main channel layer,
a barrier layer on the main channel layer and including a material having an energy band gap different from an energy band gap of the main channel layer,
a main gate electrode on the barrier layer,
a gate semiconductor layer arranged between the barrier layer and the main gate electrode, and
a main source electrode and a main drain electrode disposed on respective sides of the main gate electrode and electrically connected to the main channel layer,
wherein the peripheral circuit element comprises:
a sub-channel layer electrically connected to the main drain electrode and including a drift region having a two-dimensional electron gas; and
a detection electrode on the sub-channel layer, and
wherein the Zener diode is electrically connected between the detection electrode and the main source electrode.

2. The semiconductor device of claim 1, wherein:
the peripheral circuit element comprises a sub-drain electrode electrically connected to the sub-channel layer, and
the sub-drain electrode is disposed on a same layer as the main drain electrode.

3. The semiconductor device of claim 1 or 2, wherein the peripheral circuit element comprises a sub-source electrode electrically connected to the main source electrode and spaced apart from the sub-channel layer,
wherein the sub-source electrode is disposed on a same layer as the main source electrode, and
wherein the sub-channel layer is disposed on a same layer as the main channel layer.

4. The semiconductor device of any preceding claim, wherein:
an anode of the Zener diode is electrically connected to the main source electrode, and
a cathode of the Zener diode is electrically connected to the detection electrode.

5. The semiconductor device of any preceding claim, wherein a width of the sub-channel layer is smaller than a width of the main channel layer.

6. The semiconductor device of any preceding claim, wherein the peripheral circuit element comprises a resistance element, the resistance element including a resistance of the drift region of the sub-channel layer between the main drain electrode and the detection electrode.

7. The semiconductor device of claim 6, wherein the resistance element comprises a contact electrode on the sub-channel layer and arranged between the detection electrode and the main drain electrode.

8. The semiconductor device of claim 7, wherein the contact electrode is disposed on a same layer as the detection electrode and comprises a same material as the detection electrode.

9. The semiconductor device of any preceding claim, wherein the peripheral circuit element comprises:
a sub-drain electrode electrically connected to the sub-channel layer and disposed on a same layer as the main drain electrode; and
a sub-gate electrode on the sub-channel layer and arranged between the detection electrode and the sub-drain electrode.

10. The semiconductor device of claim 9, wherein the sub-gate electrode is disposed on a same layer as the main gate electrode and comprises a same material as the main gate electrode.

11. The semiconductor device of claim 9 or 10, wherein the peripheral circuit element comprises a diode element comprising the sub-gate electrode,
wherein the sub-gate electrode is electrically connected to the detection electrode, and
wherein a breakdown voltage of the Zener diode is smaller than a threshold voltage of the diode element.

12. The semiconductor device of any one of claims 9 to 11, wherein:
the barrier layer extends above the sub-channel layer, and
the barrier layer is arranged between the sub-channel layer and the sub-gate electrode.

13. The semiconductor device of claim 12, wherein the peripheral circuit element comprises a sub-gate semiconductor layer arranged between the barrier layer and the sub-gate electrode.

14. The semiconductor device of claim 12 or 13, wherein the peripheral circuit element comprises:
a protective layer covering the barrier layer; and
a connection portion on the protective layer and connecting the sub-gate electrode with the detection electrode.

15. The semiconductor device of any preceding claim, further comprising a separation structure arranged on the sub-channel layer between the peripheral circuit element and the main transistor, the separation structure extending into the barrier layer.
